Europäisches Patentamt

European Patent Office

Office européen des brevets

(19)

(11) Publication number: **0 233 184 B1**

(12) **EUROPEAN PATENT SPECIFICATION**

(45) Date of publication of patent specification: **01.04.92**  (51) Int. Cl.⁵: **B08B 3/04**

(21) Application number: **85906130.1**

(22) Date of filing: **20.11.85**

(86) International application number:
**PCT/US85/02318**

(87) International publication number:
**WO 87/00094 (15.01.87 87/01)**

(54) SEMICONDUCTOR WAFER FLOW TREATMENT.

(30) Priority: **24.06.85 US 747894**
**24.06.85 US 747895**

(43) Date of publication of application:
**26.08.87 Bulletin 87/35**

(45) Publication of the grant of the patent:
**01.04.92 Bulletin 92/14**

(84) Designated Contracting States:
**AT BE CH DE FR IT LI LU NL SE**

(56) References cited:
**GB-A- 1 298 006     GB-A- 2 159 328**
**US-A- 3 826 377     US-A- 4 015 615**
**US-A- 4 235 650     US-A- 4 328 081**

**N Komax Systems, Inc., Brochure,
"Simultaneous Division, Cross-Current and
Back-Mixing"**

(73) Proprietor: **CFM TECHNOLOGIES, INC.**
**625 Dager Road P.O. Box A**
**Penllyn, PA 19422(US)**

(72) Inventor: **McCONNELL, Christopher, F.**
**978 South Gulph Road**
**Gulph Mills, PA 19406(US)**
Inventor: **WALTER, Alan, E.**
**606 Brecknock Drive**
**Exton, PA 19341(US)**

(74) Representative: **Slight, Geoffrey Charles et al**
**Graham Watt & Co. Riverhead**
**Sevenoaks Kent TN13 2BN(GB)**

Rank Xerox (UK) Business Services

## Description

### BACKGROUND OF THE INVENTION

This invention relates to materials processing. More particularly, it relates to treatment of wafers such as semiconductor wafers with liquids.

In the process of fabricating semiconductor wafers, the need to avoid contamination by impurities takes on critical importance. Even in the "clean rooms" of semiconductor fabrication facilities contamination can arise from human contact, solvent residues and oils from various operations, metals, dust particles, organics and other materials present in processing reagents. Many of the processing steps involved in fabricating semiconductor wafers require that the wafers be exposed to a fluid, i.e., oxidizing agents, etchants, and washing and rinsing agents. In order to achieve acceptable yields, it is important that each of these steps be carried out in a manner that minimizes the potential for contamination.

Pre-diffusion cleaning is a good example of a step in the process of fabricating semiconductor wafers which must be carefully controlled to avoid contamination. Since the diffusion step in semiconductor processing is intended to "drive-in" desired dopant atoms through high temperature exposure, any contaminants left on the wafer surface after cleaning may also be driven into the wafer and can result in faulty electrical properties.

Pre-diffusion cleaning conventionally is accomplished by loading the wafers into a basket, such as the baskets described in U.S. patents 3,923,156 and 3,926,305, and then immersing the wafers and basket in a series of open sinks or tank baths. Usually the cleaning method involves contacting the wafers first with a strong oxidizing agent, such as sulfuric acid, rinsing with water, then contacting the wafers with an etchant, such as hydrofluoric acid, and then rinsing again. Open baths mounted in countertops pose significant safety problems to technicians who may be exposed to the active reagents or their fumes. Moreover, airborne impurities can and do contaminate the reagents and rinse water, leading to reduced semiconductor yields.

In an effort to avoid open baths, enclosed spray-cleaning devices have been proposed. These typically also incorporate spin-drying mechanisms. One example of such a spin-rinser-dryer is disclosed in U.S. patent 3,760,822. Although this method is an improvement over immersion techniques from the standpoint of safety and airborne contaminant control, the combination of agressive chemicals and many moving parts results in substantial maintenance problems as well as particulate contamination. Moreover, these designs subject the fragile semiconductor wafers to substantial mechanical stresses.

The need for better systems for treating semiconductor wafers with liquids has become more acute as the circuit element density of solid state devices has increased. Any such system should be capable to treating large numbers of wafers at one time and should be amenable to automated operation. Moving parts and the potential for contamination should be minimized. At the same time, worker exposure to aggressive reagents and/or their fumes should be minimized. A simple, efficient system that permits the safe treatment of semiconductor wafers with liquid in an automated and totally enclosed manner would satisfy a long felt need in the industry. If such a system could improve chip yield by even a fraction of a percent, it would greatly benefit the semiconductor manufacturing industry.

### SUMMARY OF THE INVENTION

It has now been discovered that a simple, efficient system for treating semiconductor wafers with liquids resides in a vessel which serves to store a plurality of the wafers while at the same time serving as the walls of a treatment solution flow line. Such a vessel permits the flow treatment processes to be carried out in a totally enclosed manner, thereby avoiding safety and contamination problems. Additionally, the vessel may be designed to ensure that all of the wafers are properly exposed to the flow, turbulence or eddy currents are minimized, and pockets where residual contaminates may collect are eliminated.

Broadly one concept of the invention is to provide a semiconductor wafer treatment vessel which may be used singly, or in series with other similar or identical vessels, to form an integral part of a wafer treatment liquid flow line. The vessels and liquid flow lines, gaskets, connectors and other parts of the system are preferably fabricated from materials which are inert to the treatment liquid, e.g., fluorinated polymers. Furthermore, the vessels are designed to avoid any pockets or recesses where spent solutes or particulates removed from one batch of the wafers may collect or be temporarily retained only to contaminate the next batch, and to avoid creation of liquid flow peculiarities which might serve to concentrate solutes. Thus, microcracks where parts join, interior acute angles and other sharp corners, and recesses are avoided so that all treatment liquid flows through the vessel and is transported away to be discarded or repurified.

A system uses the vessel with an input element designed to impart plug-flow to a liquid introduced into the vessel to displace another. As used herein, the term "plug-flow" refers to a liquid flow having a front, transverse to the direction of flow, defined by a generally disc-shaped volume of liquid which contains a concentration gradient produced by the mixing of the two liquids at their interface. The concentration gradient of the front is thinner than the length of the flow path through the vessel. During displacement of liquid contained in the vessel with a different liquid, the front moves along an axis extending between the vessel inlet and vessel outlet, and may expand slightly in thickness, resulting in uniform displacement. This is to be contrasted with non plug-flow displacement wherein the introduction of a liquid produces a narrow stream which creates swirling currents and random mixing during transition of liquids within the vessel.

A treatment apparatus constructed in accordance with the invention can increase the semiconductor yield attained using an enclosed semiconductor wafer treatment vessel because the apparatus achieves more reproducible and more uniform treatment of all wafers within the vessel.

In one aspect, and proceeding from the conventional open sink or tank baths into which wafers are inserted in baskets, as typified, e.g. in US Patent 3,923,156, the invention provides an apparatus for treating semiconductor wafers with a sequential flow of liquids such that all regions of radial surfaces of each wafer are exposed to substantially the same concentrations of a treatment solution for substantially the same time interval, characterized by

a vessel for containing wafers comprising an enclosure defining a treatment liquid inlet opposed to a treatment liquid outlet, the direction of liquid flow through said enclosure between said inlet and outlet defining an axis; and

a liquid-input element in fluid communication with said treatment liquid inlet comprising means for imparting plug flow along said axis to a first liquid introduced into said enclosure to displace a second liquid disposed therein.

The wafer-containing vessel includes an internally disposed wafer support element for holding wafers during the treatment process or structure for supporting a conventional wafer carrier. Preferably, the input element includes a flow expander which increases the cross-sectional flow area of a liquid introduced into the wafer-containing vessel. That is, a flow having a relatively small cross-sectional area entering the flow-expander exits the expander having a larger cross-sectional area, typically of the same dimensions as the vessel. The expander is employed in combination with a flow-diverting surface disposed upstream for imparting to the liquid a flow vector transverse to the direction of flow. In one embodiment, this flow diverting surface is a fixed surface, preferably in the form of a helix extending 360° about an axis disposed in the direction of flow. In another embodiment, the flow diverting surface may be a fixed, perforated baffle which is secured to the expander downstream of the expander outlet portion. The baffle may be used either with or without an associated helical flow diverting surface. Alternatively, the surface may comprise a helix or other shape disposed for rotation about the axis. By controlling the rotational velocity of the helix, plug-flow can be maintained despite variations in fluid viscosity, density, and flow rates. The best use of a rotating flow diverter is with more rapidly flowing liquids such as hydrofluoric acid.

In another embodiment, the flow diverting surface consists of one or more fixed, perforated baffles which are secured to the expander upstream of the vessels. The baffle or baffles may be used either with or without an associated helical flow diverting surface.

US-A-4,235,650 describes a treatment vessel for semiconductor wafers in which a stream of inert gas provides transport for a dopant. The vessel is in the form of an open tube in which the wafers are supported on a holder.

Proceeding from this prior art the invention includes a vessel for use in an apparatus of the invention for treating semiconductor wafers with a sequential flow of liquids, said vessel enclosing a treatment region and containing means for supporting a wafer carrier containing wafers, or wafers in the treatment region, said vessel having opposed lateral walls adapted to enclose therebetween a plurality of the wafers and defining open ends characterized in that said open ends are substantially coextensive with the treatment region enclosed by said lateral walls said open ends defining respectively said treatment liquid inlet and said treatment liquid outlet, and in that first sealing means is provided about one open end for sealingly engaging means communicating with the treatment liquid inlet, and second sealing means is provided about the other open end for sealingly engaging means communicating with the treatment liquid outlet.

The invention also provides a method of exposing the radial surfaces of a plurality of semiconductor wafers to a treatment solution, e.g. hydrofluoric acid solution, such that all regions of the radial surfaces of each wafer are exposed to substantially the same concentrations of solution for substantially the same time interval. The method of the invention which likewise proceeds from the conventional pre-diffusion cleaning method using open sink or tank baths of treatment solution, includes the steps of disposing the wafers in an enclosure defining a solution inlet and solution outlet, introducing a first liquid into the enclosure, inducing plug flow of the treatment solution along an axis extending between the vessel inlet and outlet to displace the first liquid and, after a selected time, inducing plug flow of a second liquid along the same axis to displace the solution. Preferably, the plug flows are induced by passing the liquids through an input element which includes an expander and a flow diverting surface of the type described above.

The operational advantages of the method and apparatus constructed in accordance with the invention result from the action of the plug-flow imparting structure. The plug-flow imparting element permits uniform displacement of the first liquid by the second in a manner analogous to the displacement of the liquid content of a syringe by the syringe plunger. That is, after passing the plug-flow imparting element, the treatment liquid enters the vessel, evenly displaces the first liquid, and pushes it out of the vessel.

It should be understood that the displacement action of the liquid being introduced on the liquid within the vessel is less well defined than the action of a syringe plunger on the syringe fluid content. Rather, input of the second treatment liquid is understood to result in a narrow front containing a concentration gradient which moves along the interior of the vessel in a downstream direction, i.e., in the direction from the inlet of the vessel to the outlet. The front spans the cross-section of the interior of the vessel transverse to the direction of flow.

An apparatus as described above is incorporated into a line for carrying liquids for semiconductor treatment. The line is fitted with one or more valves or the like for temporarily interrupting and changing liquid flow. Wafers may then be loaded into the vessel, and the vessel may be sealed in line. Such a system can permit hydraulically full, high flow circulation. It can also assure uniform, full contact wetting, reduce reagent consumption, prevent back eddying of impurities and filming effects during etching, lead to more consistent localized acid concentrations, and generally result in more consistent, uniform treatment of wafers and improved semiconductor yields. Furthermore, because the operation is totally enclosed, the intrusion of airborne contaminants and carbon dioxide is essentially eliminated, and the danger of operator exposure to dangerous chemicals is minimized. Such treatment stations may be used to conduct pre-diffusion cleaning, rinsing, etching and other batch operations including drying. Furthermore, use of the invention decreases handling and permits tight control of treatment time, temperature, and endpoint conductivity of rinse solutions.

The invention contemplates an automated system wherein plural vessels incorporated within a fluid flow line are loaded with wafers, or with a conventional carrier containing a plurality of wafers, e.g., through a sealable opening disposed in a lateral wall of each vessel. A series of liquid processing steps may then be carried out in sequence without the need to move the wafers from one bath to another.

In one illustrated embodiment, the invention provides a semiconductor treatment station disposed in a fluid flow line. The station comprises a single wafer vessel, or plural wafer vessels arranged serially, which consist of opposed lateral walls disposed about an axis parallel to the direction of fluid flow defining a fluid-tight compartment having opposed open ends. Each vessel includes internal structure for supporting a plurality of planar wafers, oriented with the plane of the wafers parallel to the flow axis. Preferably the wafers are contained in a wafer carrier. Each vessel has a sealable opening, defined by at least a portion of at least one of the lateral walls, which permits the introduction and withdrawal of the wafers, and may be sealed by means of a panel, door or the like. A liquid inlet is disposed at one open end of the vessel or series of vessels, and a liquid outlet is disposed at the opposite end. The inlet and outlet are connected to liquid conduits, which in turn are connected to one or more sources of treatment liquid one or more spent liquid drains, or means for reclaiming liquids for reuse. In certain situations, sequential treatment steps may involve reversing the direction of liquid flow, in which case the inlet and outlet reverse roles.

In preferred aspects of this illustrated embodiment, the vessels include internally disposed structure for nesting a wafer carrier in a selected position therewithin. The inlet includes an expander which expands the cross-section liquid flow from the narrow flow lines to the larger dimensions of the vessels. Thus the dimensions of the inlet and outlet are substantially coextensive with the dimensions of the open ends of the vessels. A means for imparting plug flow to a liquid introduced into the vessels through the expander to displace another liquid contained in the vessels is preferably included upstream of the expander. The plug flow imparting means preferably takes the form of a 360° helix disposed immediately upstream of the expander.

In another illustrated embodiment, each vessel defines an enclosure having lateral walls defining opposed open ends. One or more horizontal bars or other protrusions from the interior side walls of the vessel support a wafer carrier within the vessel. Optionally, the vessel includes structure for locating the wafer carrier in a selected position within the vessel. Sealing means, e.g., elastomeric gaskets, are disposed about one or both open ends of each of the vesels so that each vessel may be sealingly engaged with another, with a liquid inlet, or with a liquid outlet. The vessels may be sealed together by pneumatically compressing the elastomeric gaskets. In addition, an expander fits onto a terminal vessel and serves to expand the cross-sectional flow area of treatment liquid as it is introduced into the vessels so that each of the wafers is fully exposed. Preferably, a flow diverting surface such as a 360° helix disposed upstream of the expander is employed to aid in expansion of the cross-sectional liquid flow as it passes through the expander. This results in "plug flow" of a liquid introduced into the vessels to displace another. The opposite terminal vessel may be sealed to an extractor which serves to reduce the liquid flow from the cross-sectional dimensions of the vessels to those of the liquid flow line so that the treatment liquid can be removed while minimizing turbulent flow and eddy currents. Preferably, the apparatus is designed such that the direction of liquid flow can be reversed. In that case the expander and extractor exchange roles.

The system described above permits hydraulically full, high flow circulation, assures uniform, full contact wetting, reduces reagent consumption, prevents back eddying of impurities and filming effects during etching, leads to more consistent localized acid concentrations, and generally results in more consistent, uniform treatment and improved semiconductor yields. Furthermore, because the operation is totally enclosed, the intrusion of airborne contaminants and carbon dioxide is eliminated, and there is no danger of operator exposure to dangerous chemicals. Such treatment stations may be used to conduct pre-diffusion cleaning, rinsing, etching and other batch operations including drying. Furthermore, use of the invention decreases handling and permits tighter control of treatment time, temperature, and endpoint conductivity.

In view of the foregoing, it should be clear that various changes and modifications can be made in the illustrated embodiments of the invention disclosed below without departing from the scope of the invention as defined by the claims.

## BRIEF DESCRIPTION OF THE DRAWINGS

Fig. 1A is a partly broken-away, perspective view of a first embodiment of the vessel of the invention showing a wafer carrier supported and nested therein;

Fig. 1B is a top plan view of the vessel of Fig. 1A;

Fig. 1C is a cross-sectional view of two vessels of the type shown in Fig. 1A shown in serial, sealing engagement;

Fig. 1D is a top perspective view of another modular treatment vessel of the invention for directly holding wafers in a flow path;

Fig. 1E is a bottom perspective view of the vessel of Fig. 1D;

Fig. 2A is a perspective view of a second embodiment of the vessel of the invention showing a lift for gently nesting a wafer carrier therewithin;

Fig. 2B is a top plan view of the vessel of Fig. 2A;

Fig. 3 is a perspective view of a third embodiment of the invention illustrating an expander and extractor connected to a liquid flow line and to a two-compartment vessel having a panel fitted with wafer carrier supports;

Fig. 4 is a perspective view of a fourth embodiment of the vessel of the invention showing two wafer carriers disposed therein;

Fig. 5 is a perspective, partly broken-away view of a fifth embodiment of the invention similar to that of Fig. 4, but adapted to receive plural individual wafers instead of a wafer carrier; and

Fig. 6 is a schematic cross-sectional illustration of an embodiment of a system of the invention including an exemplary treatment station comprising a two-compartment vessel constructed in accordance with the invention.

Fig. 7 is a schematic cross-sectional view of a treatment station constructed in accordance with the invention for treating semiconductor wafers with liquids during the loading stage;

Fig. 8 is a schematic view of the treatment station of Fig. 7 during a liquid treatment stage;

Figures 9, 10 and 11 are graphs of reagent concentration over a semiconductor wafer surface vs. time illustrating the reproducibility achievable with the apparatus and process of the invention;

Figure 12 schematically illustrates one embodiment of the invention incorporating a helical flow diverting surface and an expander;

Figure 13A is a detailed, partly schematic, cross-sectional view of a flow diverting surface mounted for rotation;

Figure 13B is a detailed, partly schematic, cross-sectional view of another embodiment of a flow diverting surface mounted for rotation;

Figure 13C illustrates another embodiment of the invention incorporating a fixed, perforated baffle as the flow diverting surface;

Figures 14A, 14B, and 14C are illustrations of the design of various wafer vessels of the type useful in the practice of the invention;

Figures 15A and 15B are schematic cross-sectional views of a treatment station constructed in accord with the invention for treating semiconductor wafers with liquids during a wafer-loading stage (Figure 15A), and a liquid treatment stage (Figure 15B).

Like reference characters in the respective drawn figures indicate corresponding parts. Some of the dimensions of the elements illustrated in the drawing have been exaggerated for purposes of more clearly explaining the nature and operation of the illustrated embodiment of the invention.

DESCRIPTION

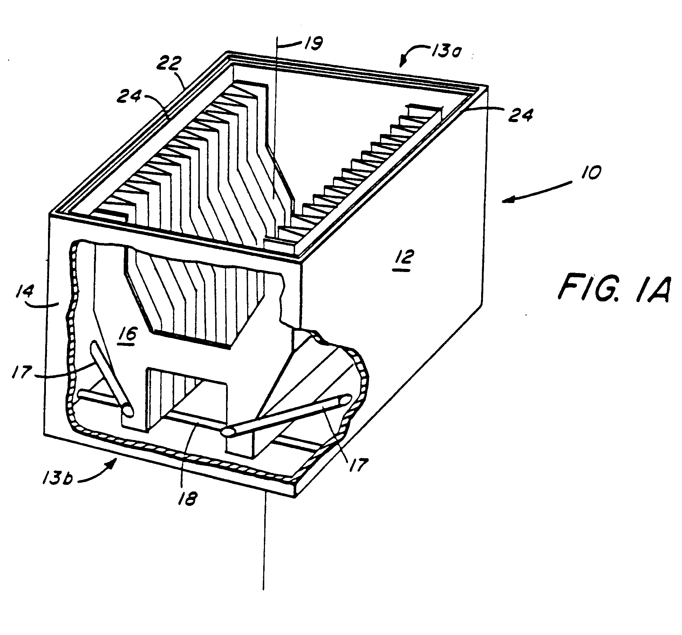

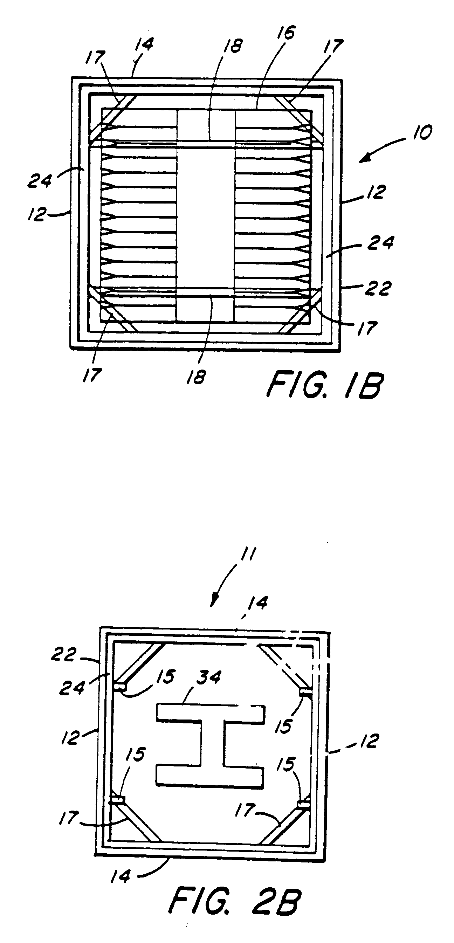

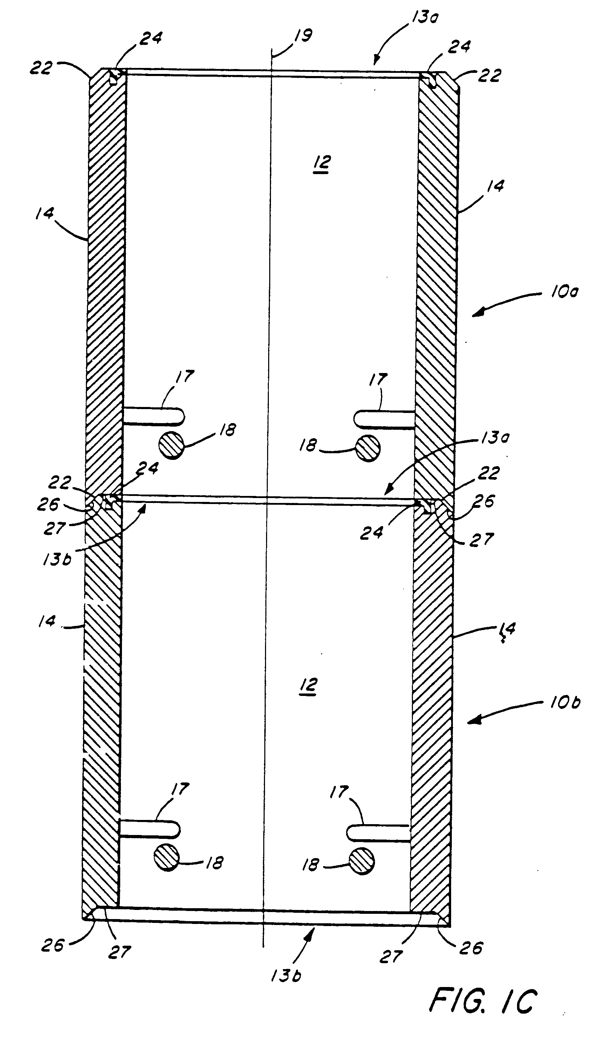

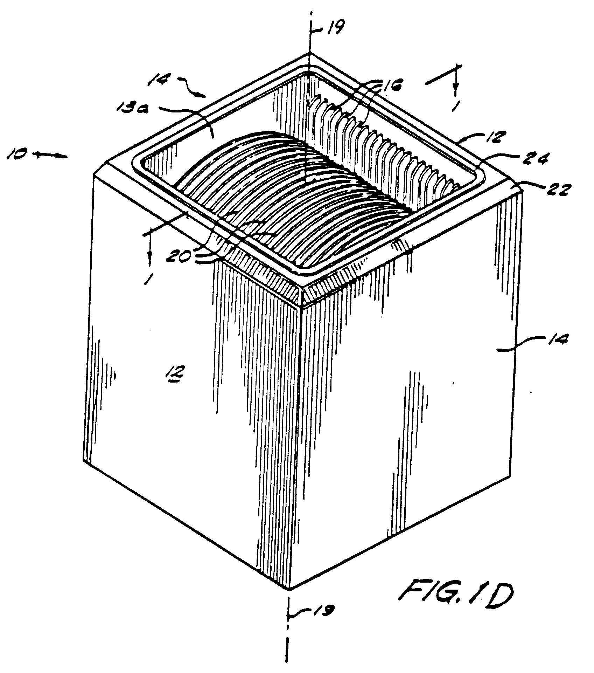

Referring to Figs. 1A, and 1B, vessels 10 are shown comprising two side walls 12 and two end walls 14. The walls define an enclosure disposed about axis 19 having a top opening 13a opposing a bottom opening 13b. Each vessel 10 also includes, for supporting and positioning a wafer carrier schematically illustrated at 16, structure comprising corner mounted positioning bars 17 and support bars 18 extending between walls 12. The surfaces of positioning bars 17 and supports bars 18 cooperate to hold the wafer carrier 16 in position. Wafer carrier 16 supports a plurality of semiconductor wafers (not shown) in aligned, parallel, spaced-apart relation to one another. the vessel and the wafer carrier for use therein will typically be designed to hold 25 wafers. The top of the vessel 10 includes a chamfered or beveled edge 22 and an elastomeric gasket 24. The beveled edge 22 and gasket 24 on the top of vessel 10 are designed to interconnect with interfitting beveled edge 26 and surface 27 on the bottom of a vessel of similar, preferably identical design, as shown in Fig. 1C.

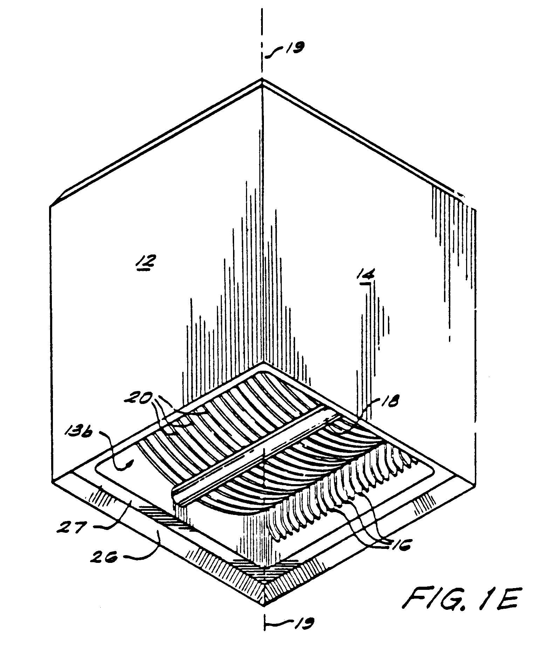

Figures 1D and 1E show top and bottom perspective views of another embodiment of a modular treatment vessel according to the present invention. In this embodiment, a plurality of grooves 16 in opposing inner walls of the vessel constitute a wafer carrier for securing the wafers aligned in the flow path. A support 18 comprises a cross bar extending between the opposing inner walls transverse to the wafer carrier 16. Like-numbered components in the drawings of this embodiment correspond to those of Figs. 1A-1C.

The interconnection of the vessels are illustrated in Fig. 1C, wherein two vessels 10a and 10b are shown in cross section nested together. The chamfered top edge 22 of vessel 10b and beveled bottom 26 of vessel 10a are shown in engagement. Gasket 24 is held in position by slots formed in the top of lateral walls 12 and 14. As illustrated, when two vessels such as 10a and 10b are nested together, beveled edges 22 and 26 interfit, and gasket 24 is urged against surface 27 to form a fluid-tight seal between the vessels. Preferably, the seals bulge slightly inwardly toward the wafers so that pockets where liquid might collect are eliminated.

Beveled edge 22 and gasket 24 of vessel 10a can interfit with another vessel (not shown), of the same or a different design, having an interfitting bevel and sealing surface like those illustrated at 26 and 27. Also, one or more additional vessels may be nested below vessel 10b and will have appropriate interfitting sealing means for mating with surfaces 26 and 27.

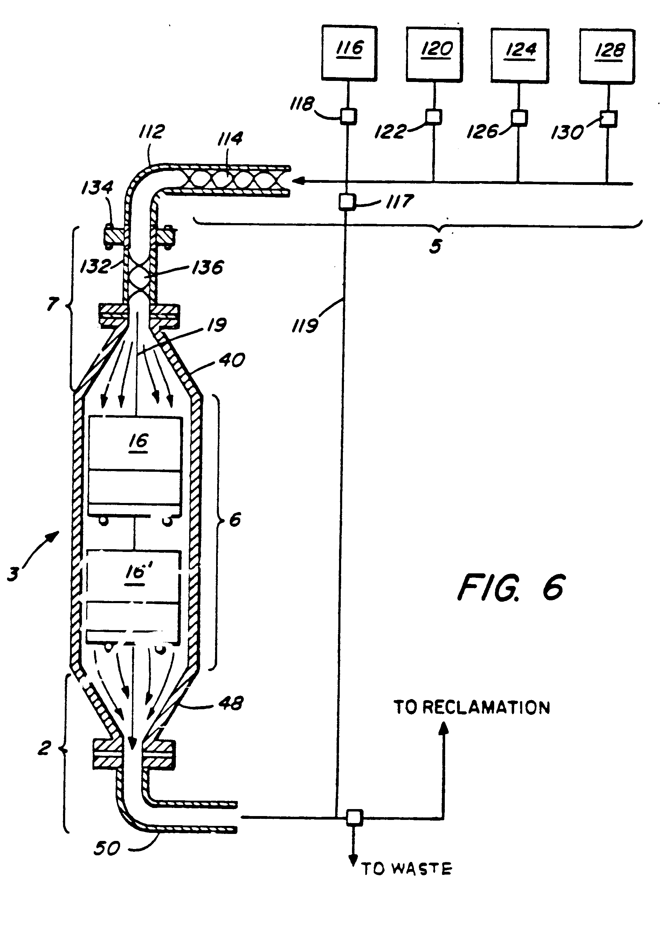

The terminal vessels in a series of nested vessels such as is depicted in Fig. 1C comprise sealing means for sealing interconnection with a wafer treatment liquid inlet and a wafer treatment liquid outlet, or structure communicating with the inlet and outlet. The seals may comprise and preferably do comprise the same structure of interfitting chamfered edges, gasket, and surfaces as are employed in interconnecting the vessels. Thus, the liquid inlet and outlet used to urge a hydraulically full flow of liquid in a direction parallel to flow axis 19 will have mating parts for sealingly engaging the assembled vessels. For example, an expander 40 (illustrated in Fig. 6) will have a lower mating edge comprising a beveled surface and a sealing surface identical to the surfaces 26 and 27 on vessel 10b of Fig. 1C. An extractor 48 (illustrated in Fig. 6) will have a upper mating edge comprising a beveled edge and gasket identical to surface 22 and gasket 24 on vessel 10b of Fig. 1C.

Although the gasket 24 is shown fixed to the top edge of the vessels 10, it should be clear that the gasket may also be carried by the bottom edge and that various other inter- connecting edge arrangements can be designed by those skilled in the art. The object in any such design should be to assure sealing engagement between the mating parts and to facilitate automated loading, interfitting, and other manipulation of the vessels.

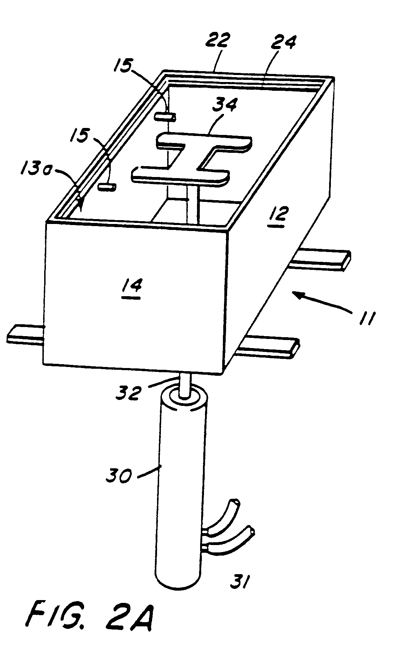

Figs. 2A and 2B show an alternative embodiment 11 of a vessel constructed in accordance with the invention. Like the vessel of Figs. 1A, 1B, and 1C, it comprises lateral sidewalls 12 and endwalls 14 defining an enclosure for a wafer carrier, and includes internally disposed wafer carrier positioning bars (17). However, in place of the wafer support bars extending across the internal dimensions of the vessel are hanging supports 15 protruding from sidewalls 12 below the upper open end 13a of the vessel 11. These serve to support a wafer carrier containing wafers (not shown) which rests on the top surface of supports 15 and is suspended within the vessel 11.

Figs. 2A and 2B also illustrate an examplary device for placing a loaded wafer carrier within a vessel of the invention. It comprises a hydraulic cylinder 30, serviced by hydraulic fluid lines 31, which imparts linear motion to a hydraulic piston 32 and its associated wafer-supporting platform 34. With the piston extended as shown in Fig. 2A a wafer carrier is rested on platform 34, then cylinder 30 is actuated to lower the platform and the carrier into the vessel 11, thereby positioning the carrier between positioning bars (17) and suspending it on supports 15. After the vessel has been placed in line as disclosed hereinafter and the wafers have been treated, the carrier loaded with wafers may be removed by the hydraulic piston 32 by reversing the procedure just described.

The embodiments of the vessel of the invention shown in Figs. 1 and 2, after being loaded with wafer carriers containing wafers, are used singly or engage with other vessels as shown in Fig. 1C, and then connected to an expander and extractor as illustrated in Fig. 6 to form fluid-tight seals between the various mating parts. This step may conveniently be accomplished by means of a hydraulic or pneumatic press (not shown) which holds the vessels in compression during processing of the wafers. After processing, the press serves to gently separate the vessel or vessels from their connection with the expander, extractor, and liquid flow lines to permit removal of the vessel and unloading of the wafer carriers.

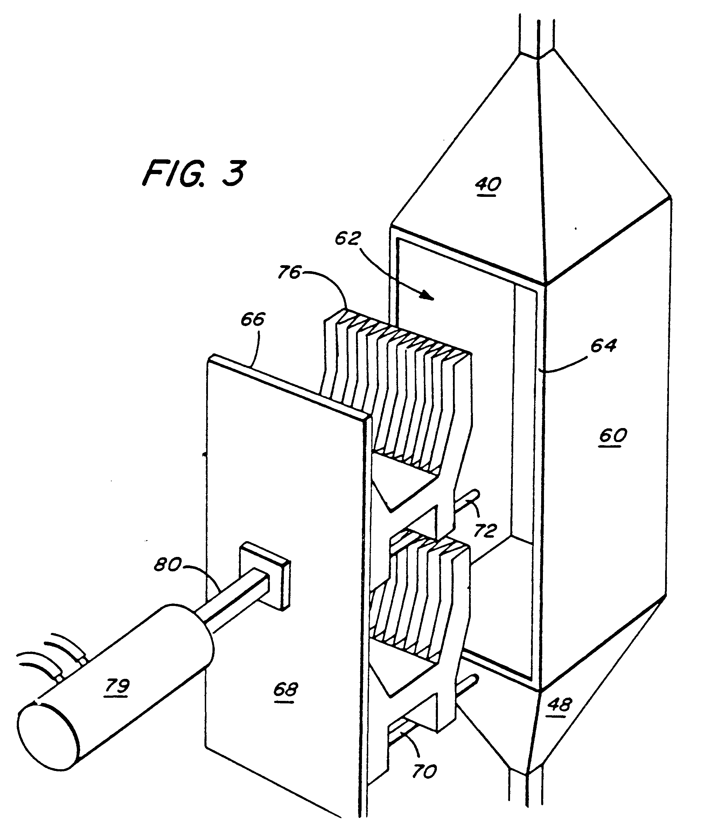

Fig. 3 schematically illustrates still another alternative design for the wafer vessels. The design of Figure 3 comprises an enclosure 60 defining a compartment for holding wafer carriers. The enclosure is made integral with an expander 40 and an extractor 48. One side of the enclosure defines an opening 62 having a sealing surface 64 which interfits with a seal 66 on a panel 68. The panel is fitted with two pairs of wafer carrier support bars 70 and 72 extending perpendicular to its interior face. Conventional wafer carriers, illustrated schematically at 76, 78, are rested on the support bars when loaded with wafers to be treated, and the panel is then sealed to opening 62 of enclosure 60 by means of hydraulic cylinder 79 and piston 80. Preferably, the interior of enclosure 60 or the panel includes structure (not shown) for nesting the wafer carriers 76 and 78 in a selected location and orientation within the enclosure 60.

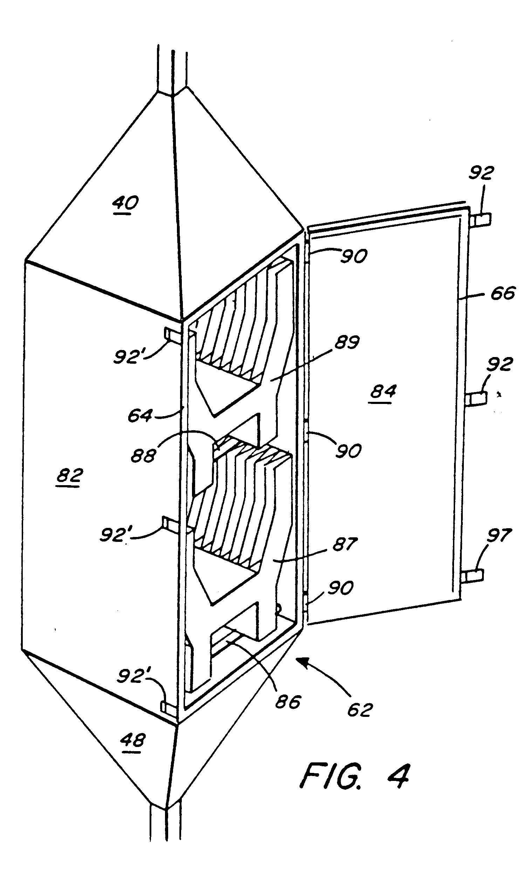

Fig. 4 depicts another embodiment of a suitable wafer vessel for use in the method and apparatus of the invention. It comprises an enclosure 82, again integrally connected to an expander 40 and extractor 48, having a sealable door 84 and internal structure, e.g., support bars 86, 88, for supporting and locating wafer carriers 87, 89 within structure 82. Hinges 90 join door 84 to enclosure 82. Fastners 92, 92' serve to seal door 84 shut and to press seal 66 on door 84 into interfitting, fluid-tight engagement with sealing surface 64.

Both of the foregoing structures have advantages in that wafer carriers of the type now commonly in use may be used to handle the wafers, and there is no need to assemble the vessels and place them in engagement with fluid input and outlet lines.

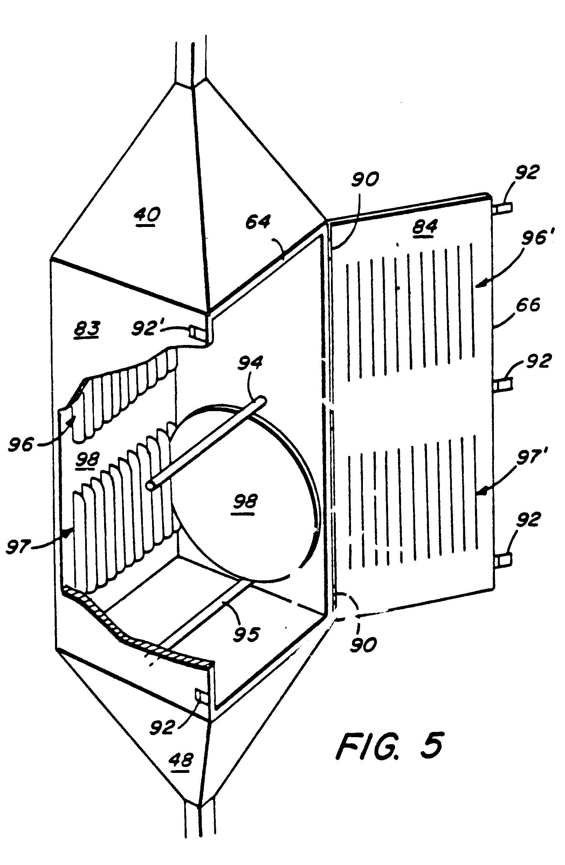

Fig. 5 illustrates another embodiment of the invention, similar to the embodiment of Fig. 4, except that the vessel 83 of Fig. 5 is adapted to receive plural individual wafers instead of a loaded wafer carrier. The vessel 83 includes single wafer support bars 94 and 95, two series of wafer-receiving grooves 96, 97 formed integrally with wall 98 of vessel 83, and two series of matching grooves 96', 97' disposed on the interior surface of door 84. Typically, 25 grooves will be provided. These structures cooperate to hold a plurality, e.g., 50 wafers (one illustrated at 98) in parallel array within vessel 83. Wafers to be processed are loaded into vessel 83 manually or robotically, and when door 84 is sealed, the wafers are supported by bars 94 and 95 and held in position with their face planes parallel to the axis of flow from expander 40 to extractor 48 (or vice versa).

Various materials may be used to construct the vessels of the invention. One preferred type of material is fluoropolymer such as polytetrafluoroethylene (sold under the trademark "Teflon" by E. I. duPont de Nemours and Company of Wilmington, Delaware). The vessels should in any case be constructed from a material which is as impervious and inert as possible to the reagents used in the treatment process and as insensitive as possible to any temperature changes during treatment. The sealing gaskets likewise are designed to be able to withstand temperatures up to 150°C or higher and to be insensitive to the chemicals used in the treatment process. Suitable gasket materials include fluorinated elastomers such as "Kalrez" and "Viton", both of which are manufactured by E. I. duPont de Nemours and Company of Wilmington, Delaware. Preferably, as shown in Fig. 1C, the gaskets are arranged so that they form a slightly convex surface inside the vessel upon compression. It is also preferred that no adhesives be used to fix the gaskets in position.

Various changes and modifications can be made to the design of the vessels themselves. Although the lateral walls are shown as flat in the illustrated embodiments, rounded walls or non-planar walls, e.g., cylinders, may be preferred in particular applications to achieve more even flow paths around the end wafers or for other purposes. Likewise, the groove designs or structure for supporting and/or positioning wafer carriers may be varied to optimize the flow characteristics, and the actual dimensions of the grooves will vary with the size of the wafers treated. Other support structures can be also designed by those skilled in the art. In most instances, all dimensions, the number of wafers per vessel, etc., will conform to standards set by the Semiconductor Equipment and Materials Institute as set forth in its annual Book of SEMI Standards.

The beveled or chamfered edges shown in the illustrated embodiment may be replaced by various other interlocking or interfitting geometries. The beveled edges are preferred because of the ease of handling in automated operations and protection from dirt or particulates which may be encountered when the vessels are placed on work surfaces. Likewise, various seal arrangements and fastening means may be used to seal a panel or door to the vessels.

The materials of construction as well as the fabrication techniques can also be varied by those skilled in the art. Although fluorinated polymers are preferred for at least interior surfaces of the vessels, various other inert plastics, metals or ceramics may be substituted depending upon the intended use. The vessels may be fabricated by machining, molding, or casting.

An important design constraint is the avoidance of eddy currents on the inside of the vessel walls and the avoidance of traps for liquid Excellent results are achieved using the vessels and system of the invention because a controlled volume of a liquid of defined, exact, and reproducible composition is flowed through the vessels about the wafers and in contact with the walls along the flow path. The reagents used are of the highest purity. Eddy currents caused by flow restrictions which might result in concentrating effects should accordingly be avoided. Likewise, cracks, concavities, and blind openings of any kind should be avoided.

Figure 6 illustrates in cross-section an embodiment of the invention which can treat plural batches of wafers so as to obtain the effects disclosed above. Broadly, the system 3 comprises a treatment liquid supply section 5, a liquid input element 7, a pair of wafer vessels 6, and a treatment liquid outlet section 2.

The schematically illustrated, exemplary treatment liquid supply section 5 comprises elements permitting selective introduction of homogeneous treatment liquids to the wafer vessels 6. In particular, the supply section 5 includes a treatment liquid supply line 112 containing a conventional static mixer 114 which is fed by a plurality of alternately useable reservoirs of fluid. The fluid reservoirs can include, for example, a reservoir 116 of hot sulfuric acid and an associated valve 118, a reservoir 120 of pressurized nitrogen and associated valve 122, a reservoir 124 of an etchent, e.g., hydrofluoric acid, and its associated valve 126, and a reservoir 128 of ultrapure water and an associated valve 130. Sulfuric acid may be passed through valve 117 and line 119 for purposes hereinafter disclosed. It is contemplated that HF and ultrapure water may be mixed in line, and that a homogeneous solution of controlled HF concentration be supplied to the wafer vessels 6 through the action of static mixer 114.

The liquid input element 7 comprises a section of tubing 132 mated with supply line 112 by means of connector 134. Disposed within tubing 132 is a fixed, helical, flow-diverting surface 136 disposed 360° about an axis 19 extending in the direction of fluid flow. A flow expander 40 serves to increase the area of liquid flow transverse to the direction of axis 19. The flow diverting surface 136, in combination with the expander 40, serves to impart plug flow to liquids introduced into wafer vessels 6 which are to displace a liquid the vessels already contain. Thus, helical surface 136 imparts to liquids passing therealong a flow vector transverse to axis 19. This has the effect of widening the front surface of liquid flow as the expander is filled. Liquid contained in the vessel is accordingly displaced as a wave or front defined by the interface zone of the newly introduced and the displaced liquid. If the two liquids are miscible, as the front advances mixing occurs within a disc-shaped volume which gets thicker as displacement continues. However, for a given flow rate and a given pair of liquids, the transition is reproducible from batch to batch and results in all radial surfaces of all wafers being exposed to substantially the same amount of active solute or the same rinsing action for the same amount of time.

In one embodiment of the invention the helical flow- diverting surface 136 is disposed within tubing 132 such that its longitudinal axis is aligned with the liquid flow axis 19. The descending pitch and surface pitch will vary for each set of flow conditions (i.e., flow rate, viscosity and vessel geometry), however, one skilled in the relevant art can empirically determine the optimal pitches for any given system. The helical surface of element 136 is preferably rotated at least 360° about the longitudinal axis. The length of the element 136 may be 3.5 inches; and the radius may be 31.75 mm (1.25 inches). The tubing 132 in which element 136 resides may have an inside diameter of 34.9 mm (1.375 inches).

The illustrated vessels 6, which correspond to the structure of Fig. 1, may be replaced by any one of the various vessel embodiments shown in Figs. 2, 3, 4, or 5 or other vessels embodying the invention. Thus, wafer carriers 16, 16' may be omitted, and wafers may be placed individually in the vessels as shown, for example, in Fig. 5.

The illustrated treatment liquid outlet section 2 includes extractor 48 and tubing 50 which directs liquid to waste or to apparatus (not shown) for reclamation and subsequent reuse of the treatment liquid. Under certain conditions, tubing 50 and extractor 48 may be used to fill vessels 6 with liquid.

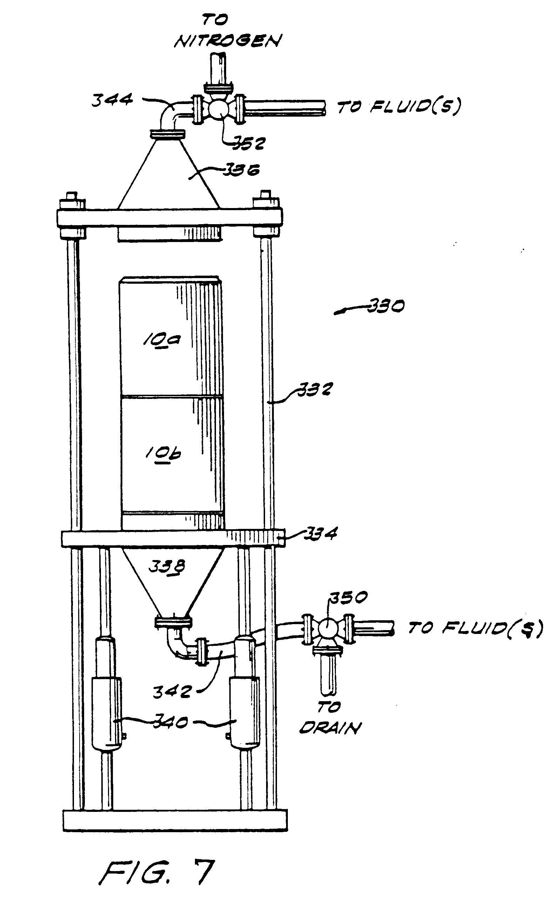

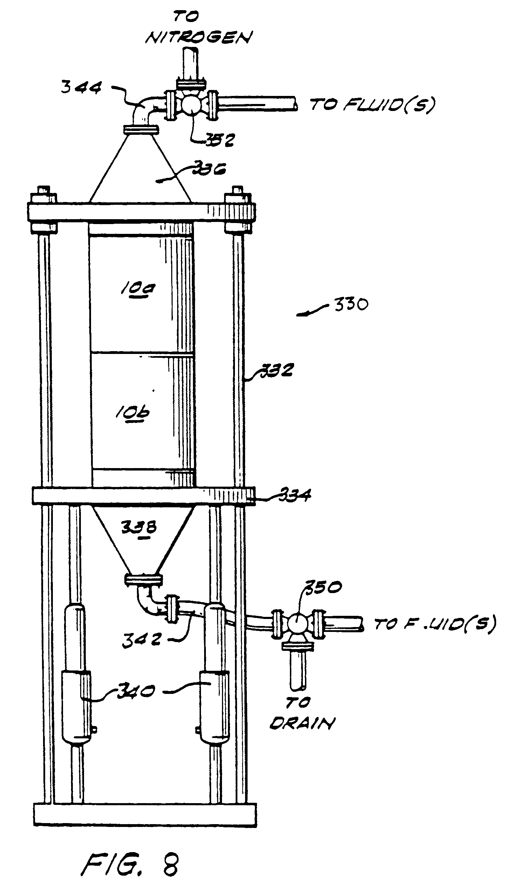

In Figs. 7 and 8, a system employing the vessel segments is shown, and its operation is depicted schematically. The system 330 comprises a support structure and stage 334 upon which a plurality of vessel segments, here illustrated as two segments, 10a and 10b, can be stacked or nested together. The vessel segments interconnect as described above and may be positioned in support structure 332 by automatic or robotic controllers. Conical structure 336 has a lower edge identical to that of the vessel segments 10 of Figs. 1A-1E. Conical structure 338 has an upper edge identical to the upper edge of the vessel segments 10. These structures 336 and 338 act as inlet diffusers or outlet extractors, depending on the direction of fluid flow. Pressure means 340 lifts the stage 334 until each of the vessel segments is sealingly interconnected, the uppermost segment 10a is sealed to inlet/outlet 336, and the lowermost segment 10b is sealed to inlet/outlet 338. In the illustrated embodiment, a pneumatic pressure means including a pneumatic cylinder 340 is used so that thermal expansion can be accommodated by the press when hot fluids are used for treatment.

The treatment liquid enters the vessel, for example, through valve 350, flexible line 342 and diffuser 338 as shown in Figs. 7 and 8, and exits the vessel through extractor 336, line 344 and valve 352. Depending upon the treatment process, the liquid can be repurified and recycled or can be discarded as waste. Fig. 7 schematically illustrates the vessel segments 10 in the course of being loaded into the system 330. In Fig. 8, the vessel is shown in its assembled form ready for liquid treatment of the wafers enclosed therein. The mechanical components which seal the vessel segments together are preferably located below the stage 334 to avoid any contamination from dust or other particulates during movement of the mechanism.

While a pneumatic press has several advantages as the means for achieving sealing engagement between vessel segments 10 and the input and output structures, many other mechanical means may be used. For example, various interfitting and interlocking mechanisms or latch mechanisms may be used.

In operation, wafers 20 are loaded into a vessel segment 10, one or more of which are stacked upon the stage 334 of the press frame 330. The pneumatic pressure means 340 is activated to lift the stage 334, sealingly interconnecting the vessel segments 10a, 10b, etc. with each other, the inlet/outlet 338 and the inlet/outlet 336. A test of the seals can then be conducted by introducing a gas such as nitrogen into the system 330 and measuring the pressure within line 344 and 342. Once the gasket seals are deemed satisfactory, the treatment liquid may be introduced through inlet/diffuser 338, passed through the vessel segments to the outlet/extractor 336, and ultimately removed through line 344. Filling with the liquid is preferably conducted from the bottom so as to avoid gas entrapment and splashing. A sequence of treatment steps can then be carried out, which may involve abrupt changes in the liquid being utilized or the direction of fluid flow. At the end of the last step, the vessel segments are drained. Draining is preferably conducted by introducing nitrogen from above and allowing the liquid to escape out the bottom. Purging flow may also be used to thoroughly dry the wafers and vessel or vessels. Finally the vessel segments are disengaged by lowering stage 334. Each segment may then be removed from the press system 330 and the wafers subsequently removed from the vessel segments for additional fabrication steps requiring individual handling.

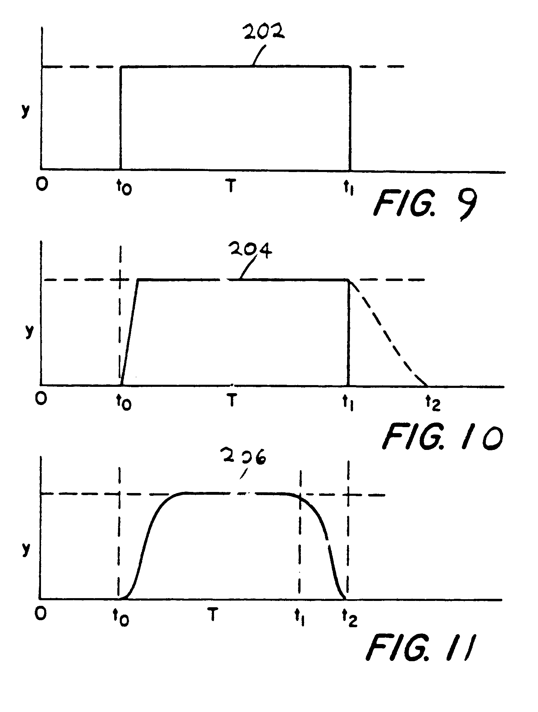

Figs. 9, 10 and 11 depict the time-dependent reagent concentration level over a semiconductor wafer surface during an exemplary semiconductor wafer processing stage conducted by an idealized method (9), a conventional method (10), and the method of the invention (11).

The exemplary processing stages depicted in each of the graphs are equivalent and correspond, for example, to a hydrofluoric acid etching stage, or a purified water rinsing stage. The time-dependent concentration curves 202, 204 and 206 have in common a rapidly rising left-side, which corresponds to a treatment reagent immersion phase. Further, each of the curves 202, 204, 206 have a falling right-side, which corresponds to a treatment reagent extraction phase. The areas under the graphs are representative of the amount of exposure of a wafer surface to the reagent during the treatment stage.

In the ideal wafer treatment method of curve 202 presented in graph (9), the entire wafer surface is immersed at once in the processing reagent during the immersion phase, and the reagent is removed or extracted at once from the entire wafer surface during the extraction phase. Stated another way, the immersion and extraction phases are of zero duration and are substantially uniform. In this idealized process, the entire surface of each wafer would be exposed to the same reagent concentration for the same time.

Curve 204 of graph (10) depicts the time dependent reagent concentration at the surface of a wafer of a conventional wet bath processing system. Unlike the ideal wafer processing system depicted in graph (9), the left-side segment of the curve 204 which corresponds the immersion phase, is not vertical. Rather, the immersion phase corresponds to the time period between the moment when a leading edge of a wafer contacts the processing reagent bath and the moment when the trailing edge is finally immersed. The slope and shape of the curve representing the immersion phase will differ from batch to batch unless the immersion is conducted by robotic control or otherwise standardized.

The right-side segment of the curve 204 corresponds to the extraction phase of a wet bath processing stage. Between the moment at which the extraction phase commences, i.e., at time $t_1$, and the moment when the surface-averaged concentration reaches zero, i.e., at time $t_2$, varying portions of the wafer surface are exposed to varying levels of reagent concentration. Reagent adheres to various portions of the wafers in an unpredictable manner, and the treatment continues in some fashion until all reagent is removed. The extraction curve therefore necessarily varies from batch to batch, and different sections of individual wafers within a batch are exposed to a slightly different treatment. Accordingly, the wet bath treatment method produces non-uniformly treated wafers, thereby reducing yield. Furthermore, unless the process is roboticallly manipulated, there exists significant uncertainty in the precision of the process-time duration.

Curve 206 of graph (11) represents the surface-average time dependent reagent concentration attained by the method and processing system constructed in accordance with the invention. As above, the left-side segment of the curve corresponds with the immersion phase of the system, while the right-side of the curve 206 corresponds with the extraction phase of the system. More particularly, the left-side segment of curve 206 corresponds to the time period between the moment when the leading edge of the front of liquid being introduced contacts a leading edge of a wafer, i.e., $t_o$, and the moment when the trailing edge of the front passes the trailing edge of the wafer. The right-side segment of curve 206 corresponds to the time period transpiring between the moment, $t_1$, when the leading edge of the front of the second liquid contacts the leading edge of the the wafer, and the moment, $t_2$, when the trailing edge of the front passes the trailing edge of the water. Note that the immersion and extraction phases of the system are more symmetrical. Using automated apparatus as disclosed herein, the curve can be made highly reproducible, with the result that each wafer in each batch is contacted with substantially the same total amount of reagent for substantially the same amount of time.

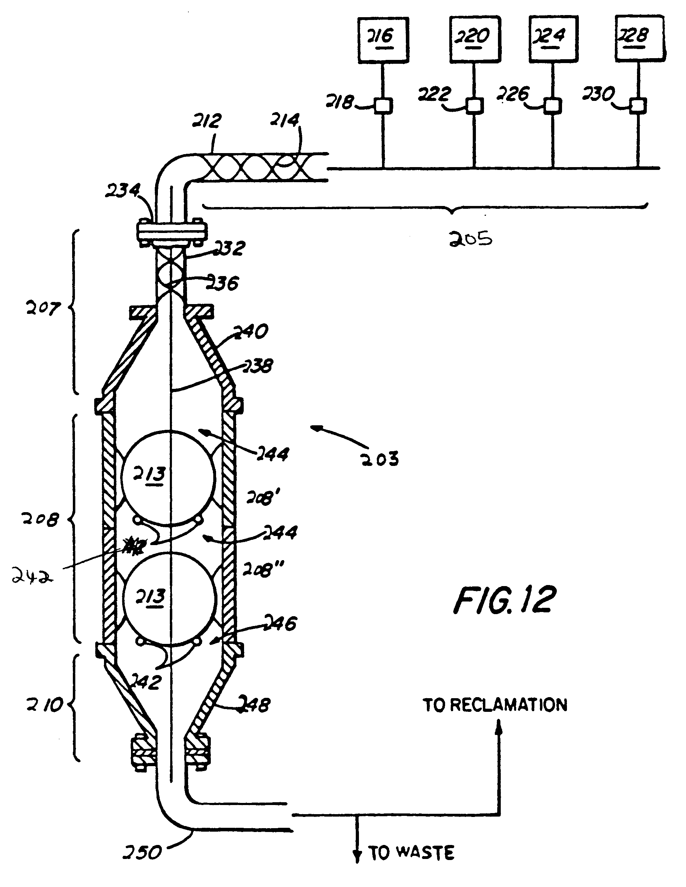

Fig. 12 illustrates an embodiment of the invention which can treat plural batches of wafers so as to obtain the effect set forth in Fig. 11. Broadly, the system 203 comprises, a treatment liquid supply section 205, a liquid input element 207, a pair of wafer vessels 208, and a treatment liquid outlet section 210.

The schematically illustrated, exemplary treatment liquid supply section 205 comprises elements permitting selective introduction of homogeneous treatment liquids to the wafer vessels 208. In particular, the supply section 205 includes a treatment liquid supply line 212 which contains a conventional static mixer 214 which is fed by a plurality of alternately useable reservoirs of fluid. The fluid reservoirs can include, for example, a reservoir of hot sulfuric acid 216 and an associated valve 218, a reservoir of pressurized nitrogen 220 and associated valve 222, a reservoir of an etchent 224, e.g., hydrofluoric acid, and its associated valve 226, and a reservoir or ultrapure water 228 and its associated valve 230. It is contemplated that HF and ultrapure water may be mixed in line, and that a homogeneous solution of controlled HF concentration be supplied to the wafer vessels through the action of static mixer 214.

The fluid input section 207 comprises a section of piping 232 mated with supply line 212 by means of connector 234. Disposed within piping 232 is a fixed, helical, flow-diverting surface 236 disposed 360° about an axis 238 extending in the direction of fluid flow. A flow expander 240 serves to increase the area of fluid flow transverse to the direction of axis 238. The flow diverting surface 236, in combination with the expander 240, serves to impart plug flow to liquids introduced into wafer vessels 208 which are to displace a liquid the vessels already contain. Thus, helical surface 236 imparts to liquids passing therealong a flow vector transverse to axis 238. This has the effect of widening the front surface of liquid flow as the expander is filled. Liquid contained in the vessel is accordingly displaced as a wave or front defined by the interface zone of the newly introduced and the displaced liquid. If the two liquids are miscible, as the front advances mixing occurs within a disc-shaped volume which gets thicker as displacement continues. However, for a given flow rate and a given pair of liquids, the transition is reproducible from batch to batch and results in all radial surfaces of all wafers being exposed to substantially the same amount of active solute or the same rinsing action for the same amount of time.

In one embodiment of the invention, the helical flow-diverting surface 236 is disposed within piping 232 such that its longitudinal axis is aligned with the fluid flow axis 238. The hellcal surface of element 236 is preferably rotated at least 360° about the longitudinal axis. The length of the element 236 may be 88.9 mm (3.5 inches); and the radius may be 31.75 mm (1.25 inches). The piping 232 in which element 236 resides may have an inside diameter of 34.9 mm (1.375 inches).

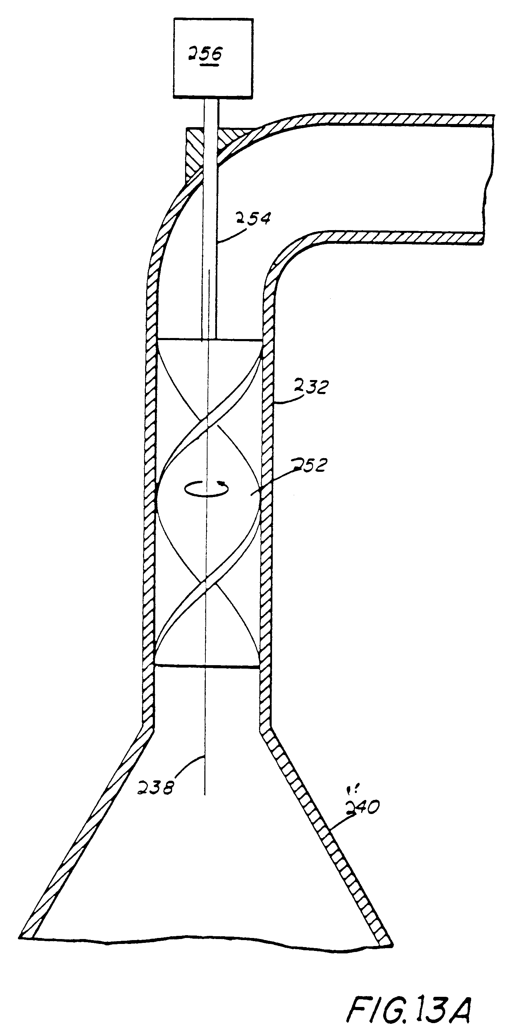

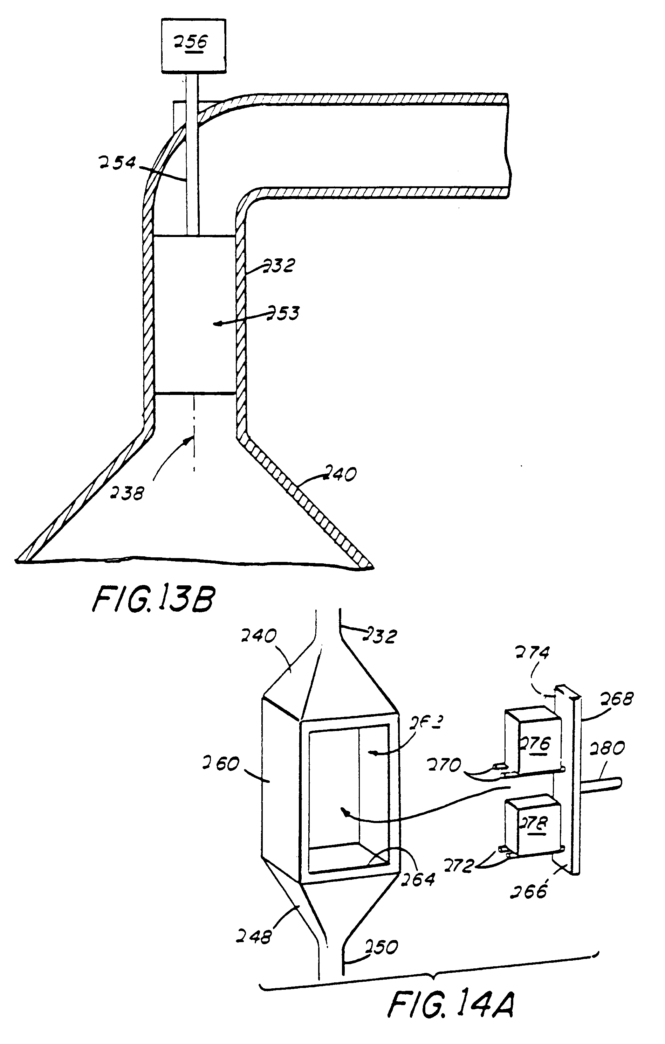

In another embodiment of the invention, the fixed flow-diverting surface of Fig. 12 is replaced by a rotatable flow-diverting surface, e.g., a helical structure of the type illustrated in Fig. 13A or a structure such as the flat plate 253 illustrated in Fig. 13B. Structure 252 and 253 is disposed within piping section 232, and mounted for rotation about the axis 238 on shaft 254. The structure 252 of Fig. 13A comprises a blade having a radius sufficient to fit snugly within the piping section 232, and a length sufficient to extend 360°. The plate 253 of Fig. 13B likewise has a width sufficient to fit snugly within piping section 232. The length of plate 253 is not critical; however, it should be sufficient to impart plug flow to liquids passing through piping section 232.

In operation, the structure 252 or 253 is driven by a variable speed motor 256, to achieve rotation about the fluid-flow axis 238. The rotational speed may be varied with the fluid flow rate and the viscosity and density of the liquid being introduced to attain consistent expanding flow in the expander 240. The correct speed of rotation can readily be determined empirically for a given set of flow conditions and a given system geometry.

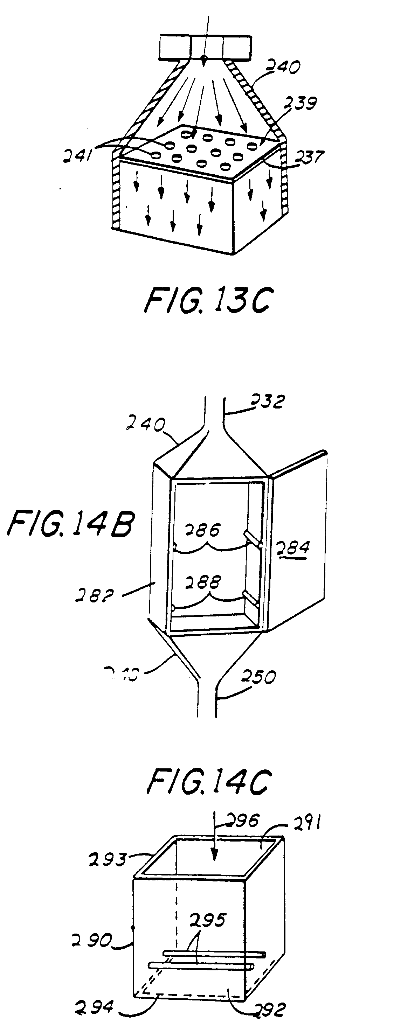

In another embodiment of the invention, the flow diverting surface takes the form of a perforated baffle 239 as illustrated in Figure 13c. The baffle 239 is disposed adjacent the output portion of expander 240 mounted to its interior walls. Baffle 239 comprises a flat, plate-like structure 237 having a plurality of generally circular or ovoid perforations 241. The number of perforations 241 and their dimensions will vary depending upon the fluid being passed through the expander 240, the fluid flow rate, and the dimensions of the system. These variables can easily be determined by one skilled in the relevant art.

The use of baffle 239 may achieve essentially the same result as the use of the alternative embodiments of this invention such as flow diverting surface 236 and structures 252 and 253. It is possible to use baffle 239 either with or without surface 236 or structures 252 or 253.

In a preferred practice, the helical flow diverting surface 236 is a fixed helix. The radius of the helix is only slightly smaller than the interior diameter of piping section 232 and may conveniently be mounted therein by means of a flange.

The vessels 208 are designed to have open ends which mate to form a smooth internal surface with the expander 240, and to hold a plurality of wafers 213 or a wafer carrier. A single vessel or plural vessels which meet and interfit may be used. Generally, the vessels are designed such that smooth fluid flow in the direction of axis 238 is promoted. Preferably, no pockets or crevices should be formed by the wafer carrier or wafer support structure.

Referring again to FIG. 12, in the illustrated embodiment, the vessels 208 each include internally disposed wafer support bars 242, an inlet end 244, and an outlet end 246. The inlet of the top vessel 208' is sealingly engaged to the outlet of the expander 240. The inlet of the lower vessel 208'' is mated with the outlet of the top vessel 208'. An extractor 248 is sealingly engaged with the outlet 246 of the lower vessel 208''.

The illustrated treatment fluid outlet section 210 includes extractor 248 and piping 250 which directs fluid to waste or to apparatus (not shown) for reclamation and subsequent reuse of the treatment fluid.

The seals joining the vessels, expander, and extractor may comprise a structure of interfitting chamfered edges, gaskets, and surfaces of the type described above.

Such a preferred seal construction bulges slightly inwardly toward the wafers so that pockets where fluid might collect are eliminated. Thus, for example, the expander 240 may have a lower mating edge comprising a beveled surface and elastomeric gasket identical to that of the outlet end 246 of vessels 208' and 208'', while extractor 248 may have an upper mating edge comprising a beveled edge and sealing surface identical to the inlet end 244 of the vessels 208' and 208''.

Various materials may be used to construct the vessel segments of the invention. One preferred type of material is fluoropolymer such as polytetrafluoroethylene (sold under the trademark "Teflon" by E.I. duPont de Nemours and Company of Wilmington, Delaware). The vessel segments should in any case be constructed from a material which is as impervious and inert as possible to the chemical reagents used in the treatment process and as insensitive as possible to any temperature changes during treatment. The sealing gaskets, if gaskets are used, are designed to be able to withstand temperatures up to 150°C or higher and to be insensitive to the chemicals used in the treatment process. Suitable gasket materials include fluorinated elastometers such as "Kalrez" and "Viton", both of which are manufactured by E.I. duPont de Nemours and Company, or "Fluoraz", manufactured by Greene, Tweed and Co. of North Wales, PA. It is also preferred that no adhesives be used to fix the gaskets in position.

Figures 14A, 14B, and 14C schematically illustrate alternative designs for the wafer vessels. The design of Figure 14A comprises an enclosure 260 made integral with an expander 240 and an extractor 248. One side of the enclosure defines an opening 262 having a seal 264 which interfits with a seal 266 on a panel 268. The panel is fitted with two pairs of wafer carrier support bars 270 and 272 extending perpendicular to its interior face 274. Conventional wafer carriers, depicted schematically at 276, 278, are rested on the support bars when loaded with wafers to be treated, and the panel is then sealed to opening 262 of enclosure 260 by means of handle 280. Preferably, the interior of enclosure 260 or the panel includes structure (not shown) for nesting the wafer carriers 276 and 278 in a selected location and orientation in the enclosure 260.

Figure 14B depicts another embodiment of a suitable wafer vessel for use in the method and apparatus of the invention. It comprises an enclosure 282, again integrally connected to an expander 240 and extractor 248, having a sealable door 284 and internal structure, e.g., rails 286, 288, for supporting and locating a conventional wafer carrier.

Both of the foregoing structures have advantages in that wafer carriers of the type now commonly in use may be used to handle the wafers, and there is no need for a press or other device for engaging the wafer vessels with the fluid input element 207 and fluid outlet element 210.

Figure 14C illustrates another design for a wafer vessel useful in the method and apparatus of the invention. It comprises an enclosure 290 having open ends 291, 292, fitted with seals 293 and 294 and a pair of wafer carrier support bars 295. Preferably, as in the embodiments of Figures 14A and 14B, structure (not shown) is included in the interior of the vessel which serves to nest the wafer carrier in position as it is lowered in the direction of arrow 296 into the vessel. The exact location and shape of such internal nesting structure necessarily depends on the type of wafer carrier to be used. After a loaded wafer carrier has been positioned within enclosure 290, the vessel is mated with others of identical design, and the stack of vessels or a single vessel is sealingly engaged with an interfitting fluid input element and fluid outlet element.

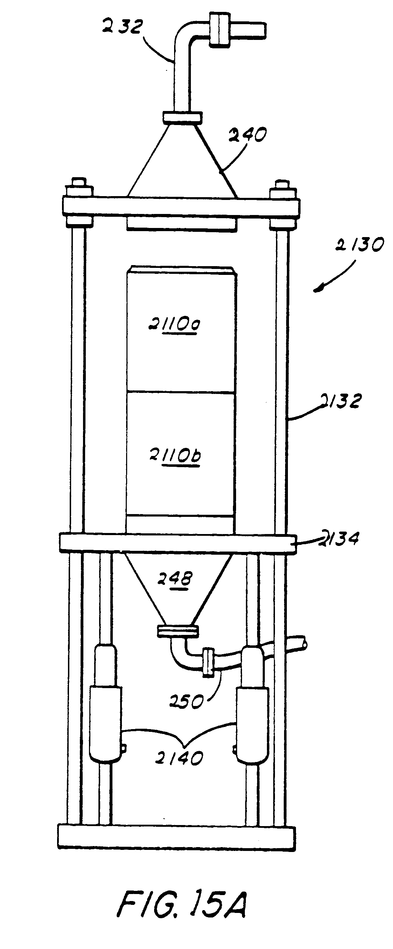

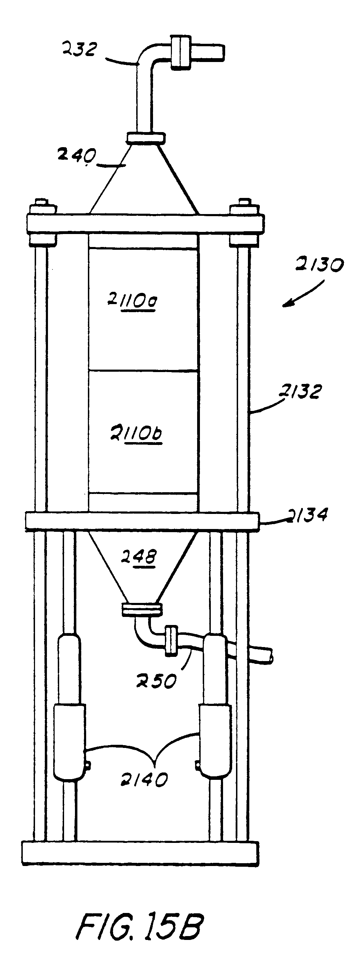

In Figure 15A and 15B, a system employing the vessel segments shown in Figure 12 or Figure 14C is shown, and its operation is depicted schematically. The system 2130 comprises a support structure 2132 and a stage 2134 upon which a plurality of vessel segments, here illustrated as two segments 2110a and 2110b, can be stacked or nested together. The vessel segments interconnect as described above and may be positioned in support structure 2132 by automatic or robotic controllers. Expander 240 has a lower edge which sealingly engages the inlet of vessel 2110a. Extractor 248 has an upper edge which sealingly engages the outlet of the vessel 2110b. Further, tubing section 232 includes a flow diverting element of the type disclosed in Figure 13A and 13B. Pneumatic cylinder 2140 lift the stage 2134 (compare Figure 15A and 15B) until each of the vessel segments is sealingly interconnected, the uppermost segment 2110a is sealed to expander 240, and the lowermost segment 2110b is sealed to extractor 248. In the illustrated embodiment, pneumatic cylinders 2140 are used so that thermal expansion can be accomodated by the press when hot fluids are used for treatment.

In operation, by way of example, wafers may be cleaned and etched thoroughly and reproducibly in preparation for diffusion by sequential contact with hot sulfuric acid, ultrapure water, a hydrofluoric acid etch solution, an ultrapure water rinse, and a drying reagent. These reagents are introduced into the vessels 6 through suitable piping and valving which, per se, form no part of this invention. At the outset, sulfuric acid from reservoir 116 is introduced into the vessels through the extractor 48 and thereafter circulated through the vessels in contact with the wafers. Ozone or another oxidizing agent may be injected into the acid effluent to oxidize impurities. The acid may be removed by introducing from reservoir 120 pressurized nitrogen through the input element 7. Thereafter, ultrapure water from reservoir 128 is circulated through the vessels to remove acid residues from the wafer surfaces and the insides of the wafer vessels and associated piping.

At a point when the rinse effluent from the vessels has a high resistivity and low particle count, indicating that thorough rinsing has been completed, hydrofluoric acid from reservoir 124 is injected into the flow of ultrapure water to produce an HF solution of precisely defined concentration. The water and hydrofluoric acid are thoroughly mixed as they pass through pipe 112 by static mixer 114. As the leading edge of the HF solution exiting mixer 114 displaces water, a certain amount of mixing occurs. As the acid solution passes through helical flow diverting surface 136, it receives a flow vector transverse to the direction of liquid flow indicated by axis 19. In fluid mechanics terminology, the flow diverting surface 136 imparts angular momentum to the HF solution.

As the HF solution enters expander 40, the angular momentum of the liquid is converted by centrifugal force into lateral momentum. Thus the liquid front tends to expand to fill the increasing cross-sectional area of the expander 40 resulting in an increase in the area of the HF solution-water interface zone. At the point where the fluid begins passing the wafers, most of the rotational velocity has dissipated, and a front defined by the water-HF solution interface zone passes through the vessels with a minimum of turbulent flow. Finally, as the front passes through extractor 48, the vessels are filled with a flow of HF solution which uniformly contacts all radial wafer surfaces and the interior walls of the vessels.

The etching stage is terminated at a selected time by abruptly ending HF injection while continuing to circulate ultrapure water. The front defined by the trailing edge of the HF solution and the leading edge of the pure water passes through the vessels, again as a plug flow, because of the combined action of the flow diverting surface 136 and the expander 40.

Because of the plug flow characteristics of the fronts produced on the introduction of the HF solution and the subsequent introduction of pure water, all wafers in a given batch and all wafers in sequential batches receive substantially the same effective exposure to the HF etch solution.

Thereafter, water circulation is continued until the resistivity and particle count of the effluent indicates rinsing is complete. At this point, the water is flushed out with nitrogen from reservoir 120. The wafers and interior surfaces of the vessels and associated piping may then be dried, for example, by introduction of a hot organic vapor such as methanol, and subsequently displacing the organic vapor with dry nitrogen or other suitable gas.

The wafers may then be removed from the vessels for further processing. This may be done by disassembling the apparatus and removing the wafers individually or the wafer carrier from the vessel if the embodiment of Figs. 1 or 2 is employed. If a vessel such as shown in Figs. 3, 4, or 5 is used, the wafers or wafer carriers may be removed by opening the access panel or door.

It will be clear to those skilled in the art that various changes or adaptations of the invention may be made for particular uses. For example, the system may be used in various other treatment steps besides prediffusion cleaning. Thus the invention can be used in wet processes generally, such as photoresist developing, wet etching and photoresist stripping. Other applications might include diffusion, oxidation, reduction, and sputtering. The apparatus may also be used to dry wafers, e.g., by alcohol treatment.

Accordingly, other embodiments are within the following claims.

**Claims**

1.  A method of exposing the radial surfaces of a plurality of semiconductor wafers to a treatment solution such that all regions of the radial surfaces of each wafer are exposed to substantially the same concentrations of treatment solution for substantially the same time interval, characterized by the steps of:

    a. disposing said plurality of wafers in an enclosure (6; 10; 11; 60; 82; 83; 208; 260; 282; 290; 2110) defining a treatment solution inlet opposed to a treatment solution outlet;

    b. introducing a first liquid into said enclosure;

    c. inducing plug flow of said treatment solution along an axis (19; 238) disposed through said enclosure between said inlet and said outlet, to displace said first liquid; and, after a selected time,

    d. inducing plug flow of a second liquid along said axis to displace said treatment solution.

2.  The method of claim 1 wherein the plug flow through said enclosure is induced by

    passing said treatment solution and said second liquid through an input element (40; 338; 240), interposed between an input line (112; 212; 232) and said enclosure, comprising means for increasing the area of liquid flow in a direction transverse to said axis; and

    imparting to the flow of treatment solution and second liquid a flow vector transverse to said axis.

3.  The method of claim 1 wherein step a includes the step of:

    a. loading a plurality of planar wafers into a vessel (10; 11; 208; 2110) having opposed lateral walls disposed about an axis (19; 238) parallel to the direction of fluid flow and defining open ends (244, 246), said loaded wafers being aligned such that the planar surfaces of each of said wafers are parallel to said axis, said vessel being connected to the fluid inlet and the fluid outlet having dimensions substantially co-extensive with said open ends, and wherein the steps of introducing liquid and inducing plug flow include:

    b. establishing a flow of fluid from said fluid inlet, through said vessel in contact with said lateral walls and about the planar surfaces of said plurality of wafers, and to said fluid outlet.

4.  The method of claim 1 wherein the step a includes the steps of:

    a. loading a plurality of wafers into a vessel (10; 11; 208; 2110) having opposed lateral walls disposed about an axis (19; 238) parallel to the direction of fluid flow and defining open ends;

    b. placing said loaded vessel in a wafer treatment fluid flow line (112; 212; 232);

    c. sealing one of said open ends (244) to means communicating with an upstream portion (40; 338; 240) of said flow line; and

    d. sealing the other of said open ends (246) to means communicating with a downstream portion (48; 336; 248) of said flow line.

5. The method of claim 4 wherein one of steps c and d is conducted by pressing together said means communicating with an upstream portion (40; 338; 240) of said fluid flow line, said vessel (10; 11; 208; 2110), and said means communicating with a downstream portion (48; 336; 248) of said fluid flow line.

6. The method of claim 4 wherein steps b to d are conducted by imparting plug flow to a liquid prior to its introduction into said vessel (10; 11; 208; 2110) to displace another liquid contained in said vessel.

7. An apparatus for treating semiconductor wafers with a sequential flow of liquids such that all regions of radial surfaces of each wafer are exposed to substantially the same concentrations of a treatment solution for substantially the same time interval, characterized by:
      a vessel (6; 10a,10b; 60; 82; 83; 208; 260; 282; 2110a,2110b) for containing wafers comprising an enclosure defining a treatment liquid inlet opposed to a treatment liquid outlet, the direction of liquid flow through said enclosure between said inlet and outlet defining an axis (19; 238); and
      a liquid-input element (40; 338; 240) in fluid communication with said treatment liquid inlet comprising means for imparting plug flow along said axis to a first liquid introduced into said enclosure to displace a second liquid disposed therein.

8. The apparatus of claim 7 wherein said liquid input element comprises means (40; 338; 240) for increasing the area of flow of said first liquid in a direction transverse to said axis (19; 238) thereby to increase the flow cross-section of said first liquid introduced into said enclosure.

9. The apparatus of claim 8 wherein said means for imparting plug flow comprises means (136; 236; 252; 253) for imparting to said first liquid a flow vector transverse to said axis.

10. The apparatus of claim 9 wherein said means for imparting plug flow comprises a fixed, e.g. helical flow diverting surface (136; 236).

11. The apparatus of claim 10 wherein said helical flow-diverting surface (136; 236) defines an angle of rotation of about $2\pi$ about said axis.

12. The apparatus of claim 9 wherein said means (136; 236; 252; 253) for imparting plug flow is disposed upstream of said means (40; 338; 240) for increasing the area of flow.

13. The apparatus of claim 7 further comprising a sealable access port (62; 262) disposed in a wall of said enclosure.

14. The apparatus of claim 7 wherein said vessel and input element comprise interfitting seals (22,24; 26,27) for connecting said treatment liquid inlet with said liquid input element.

15. The apparatus of claim 7 further comprising means (120,122,112; 352,354; 220,222,212) for introducing a purge gas into said enclosure.

16. The apparatus of claim 9 wherein said means for imparting plug flow comprising a flow diverting surface (252; 253) mounted for rotation about said axis (238).

17. Apparatus according to claim 7 wherein said enclosure (60; 82; 83; 260; 282) comprises
      i) opposed lateral walls disposed about an axis parallel to the direction of fluid flow, adapted to enclose therebetween a plurality of wafers, and defining open ends;
      ii) means (94,95,96,97; 70,72; 86,88; 270,272,286,288) for supporting wafers or at least one wafer carrier within said walls;
      iii) a sealable opening (62; 262) defined by at least a portion of at least one of said lateral walls to permit the introduction and removal of wafers; and
      iv) closure means (68; 84; 268; 284) for interfitting, sealing engagement with said sealable opening.

18. Apparatus according to claim 7 wherein the enclosure (6; 10; 11; 208; 290; 2110) includes:
      A. a plurality of separable vessels (10; 11; 208; 290; 2110a,2110b) in serial, sealing engagement, each of which comprises:
         1. opposing lateral walls disposed about an axis (19; 238) parallel to the direction of fluid flow, adapted to enclose therebetween a plurality of wafers, and defining open ends, and
         2. means (15,17; 242; 295; 16,18; 17,18) for supporting a wafer carrier containing wafers, or wafers within said walls; and
      B. first sealing means (22,24; 293) about an open end of one of said segments for sealingly engaging a fluid inlet (40; 336; 240); and
      C. second sealing means (26,27; 294) about an open end of another of said segments for sealingly engaging a fluid outlet (48; 338; 248).

19. The apparatus of claim 18 wherein each of said vessels comprises said first sealing means (22,24; 293) at one open end and said second sealing means (26,27; 294) at another open end, and said first and second sealing means are adapted for interfitting, sealing engagement with a mating vessel (106; 208''; 2110b).

20. The apparatus of claim 18 further comprising means (340; 2140) for axially compressing said vessel, the treatment liquid inlet, and the treatment outlet to urge said sealing means in fluid-tight engagement.

21. Apparatus according to claim 7 including a fluid flow line (112,50; 342,344; 212,250) and wherein the vessel comprises at least one vessel segment (10; 11; 208') comprising:

1. opposing lateral walls disposed about an axis (19; 238) parallel to the direction of fluid flow, adapted to enclose therebetween a plurality of wafers, and defining open ends;

2. means (15,17; 242; 295; 16,18; 17,18) for supporting a wafer carrier containing wafers, or wafers within said walls;

3. first sealing means (22,24; 293) about one open end for sealingly engaging means (40; 336; 240) communicating with an upstream portion of said fluid flow line; and

4. second sealing means (26,27; 294) about the other open end for sealingly engaging means (48; 338; 248) communicating with a downstream portion of said fluid flow line;

and wherein the apparatus also includes means (118, 122,126,130; 352; 218,222,226,230) for temporarily interrupting the flow of fluid in said line to permit insertion of said vessel therewithin.

22. The apparatus of claim 21 wherein said first and second sealing means comprise elastomeric material (24) and said elastomeric material is distended inwardly toward said means for supporting wafers.

23. The apparatus of claim 21 further comprising means (117,119; 350,352) for reversing the direction of fluid flow in said fluid flow line.

24. The apparatus of claim 21 further comprising means (116,118,120,122,124,126,128,130; 216,218,220, 222,224,226,228,230) for feeding serially a plurality of fluids to said fluid flow line to hydraulically fill said vessel.

25. The apparatus of claim 21 wherein said means communicating with an upstream portion of said fluid flow line comprises an expander or diffuser (40; 336; 240) and said means communicating with a downstream portion of said fluid flow line comprises an extractor (48; 338; 248).

26. The apparatus of claim 20 wherein said means for compressing includes means (340; 2140) for permitting expansion of said vessel as hot fluid passes therethrough.

27. The apparatus of claim 21 or 22 or 24 wherein said fluid inlet comprises an expander (40; 336; 240) and said fluid outlet comprises an extractor (48; 338; 248) for minimizing eddy current flow within said vessel.

28. The apparatus of claim 25 or 27 comprising means (136; 236; 252; 253) for imparting plug flow to a liquid passed through said expander and vessel to displace another liquid disposed therein.

29. The apparatus of claim 17 wherein said opening and said closure means comprises interfitting mating edges having an elastomeric seal (64,66; 264,266) disposed therebetween and said elastomeric seal distends inwardly of said vessel when said opening and closure means are sealingly engaged.

30. The apparatus of claim 7 comprising a plurality of said vessels (10; 11; 208; 290; 2110) disposed along said axis.

31. A vessel (6; 10a,10b; 10; 11; 208; 208'; 2110a; 2110a,2110b) for use in the apparatus of claim 7 for treating semiconductor wafers with a sequential flow of liquids, said vessel enclosing a treatment region and containing means (15,17; 242; 295; 16,18; 17,18) for supporting a wafer carrier containing wafers, or wafers in the treatment region, said vessel having opposed lateral walls adapted to enclose therebetween a plurality of the wafers and defining open ends characterized in that said open ends are substantially coextensive with the treatment region enclosed by said lateral walls said open ends defining respectively said treatment liquid inlet and said treatment liquid outlet; and in that

first sealing means (22,24; 293) is provided about one open end for sealingly engaging means communicating with the treatment liquid inlet and

second sealing means (26,27; 294) is provided about the other open end for sealingly engaging means communicating with the treatment liquid outlet.

**32.** The vessel of claim 31 wherein said first sealing means comprises a surface (22) for interfitting with the treatment liquid inlet.

**33.** The vessel of claim 31 comprising a plurality of separable vessel segments (6; 10a,10b; 208',208''; 290) in serial, sealing engagement, wherein the second sealing means (26,27,294) of one vessel segment engages the first sealing means (22,24; 293) of an adjacent vessel segment to form an enclosure about the wafers defined by said vessel segments.

**Revendications**

**1.** Procédé pour exposer les surfaces radiales d'une pluralité de pastilles semi-conductrices à une solution de traitement d'une manière telle que toutes les régions des surfaces radiales de chaque pastille sont exposées à pratiquement les mêmes concentrations de la solution de traitement pendant pratiquement le même intervalle de temps, caractérisé par les étapes consistant à :

a. disposer ladite pluralité de pastilles dans une enceinte (6 ; 10 ; 11 ; 60 ; 82 ; 83 ; 280 ; 260 ; 282 ; 290 ; 2110) définissant une entrée de la solution de traitement opposée à une sortie de la solution de traitement ;

b. introduire un premier liquide dans ladite enceinte ;

c. entraîner un écoulement idéal de ladite solution de traitement le long d'un axe (19 ; 238) disposé à travers ladite enceinte entre ladite entrée et ladite sortie, pour déplacer ledit premier liquide et après un temps choisi,

d. entraîner un écoulement idéal d'un second liquide le long dudit axe pour déplacer ladite solution de traitement.

**2.** Procédé selon la revendication 1, dans lequel l'écoulement idéal à travers ladite enceinte est provoqué par

le passage de ladite solution de traitement et dudit second liquide à travers un élément d'entrée (40 ; 338 ; 240) interposé entre une ligne d'entrée (112 ; 212 ; 232) et ladite enceinte comprenant un moyen pour augmenter la zone d'écoulement du liquide dans un sens transversal audit axe, et

communiquer à l'écoulement de la solution de traitement et au second liquide un vecteur d'écoulement transversal audit axe.

**3.** Procédé selon la revendication 1, dans lequel l'étape a. comporte l'étape consistant à :

a. charger une pluralité de pastilles planes dans une cuve (10 ; 11 ; 208, 2110) comportant des parois latérales opposées disposées autour d'un axe (19 ; 238) parallèle au sens d'écoulement du fluide et définissant des extrémités ouvertes (244, 246), lesdites pastilles chargées étant alignées d'une manière telle que les surfaces planes de chacune desdites pastilles sont parallèles audit axe, ladite cuve qui est raccordée à l'entrée du fluide et à la sortie du fluide ayant des dimensions pratiquement de la même étendue avec lesdites extrémités ouvertes et dans lequel les étapes d'introduction du liquide et d'entraînement de l'écoulement idéal comportent les étapes consistant à :

b. établir un écoulement du fluide à partir de ladite entrée de fluide, à travers ladite cuve en contact avec lesdites parois latérales et autour des surfaces planes de ladite pluralité de pastilles et vers ladite sortie de fluide.

**4.** Procédé selon la revendication 1, dans lequel l'étape a. comporte les étapes consistant à :

a. charger une pluralité de pastilles dans une cuve (10 ; 11 ; 208 ; 2110) comportant des parois latérales opposées disposées autour d'un axe (19 ; 238) parallèles au sens d'écoulement du fluide et définissant des extrémités ouvertes ;

b. placer ladite cuve chargée dans une ligne d'écoulement de fluide de traitement de pastilles (112 ; 212 ; 232) ;

c. fermer hermétiquement une desdites extrémités ouvertes (244) par un moyen communiquant avec une partie en amont (40 ; 338 ; 240) de ladite ligne d'écoulement, et

d. fermer hermétiquement l'autre desdites extrémités ouvertes (246) par un moyen communiquant avec une partie en aval (48 ; 36 ; 248) de ladite ligne d'écoulement.

**5.** Procédé selon la revendication 4, dans lequel une des étapes c. et d. est effectué en pressant ensemble ledit moyen communiquant avec une partie en amont (40 ; 338 ; 240) de ladite ligne d'écoulement du fluide, ladite cuve (10 ; 11 ; 208 ; 2110) et ledit moyen communiquant avec une partie en aval (48 ; 336 ; 248) de ladite ligne d'écoulement de fluide.

**6.** Procédé selon la revendication 4, dans lequel les étapes b. à d. sont effectuées en communiquant un écoulement idéal à un liquide avant son introduction dans ladite cuve (10 ; 11 ; 208 ; 2110) pour déplacer un autre liquide contenu dans ladite cuve.

7. Dispositif pour traiter des pastilles semiconductrices avec un écoulement séquentiel de liquides d'une manière telle que toutes les régions des surfaces radiales de chaque pastille sont exposées pratiquement aux mêmes concentrations d'une solution de traitement pendant pratiquement le même intervalle de temps, caractérisé par :

une cuve (6 ; 10a, 10b ; 60 ; 82 ; 83 ; 208 ; 260 ; 282 ; 2110a, 2110b) pour contenir les pastilles comprenant une enceinte définissant une entrée de liquide de traitement opposée à une sortie du liquide de traitement, le sens de l'écoulement du liquide à travers ladite enceinte étant ladite entrée et ladite sortie définissant un axe (19 ; 238), et

un élément d'entrée du liquide (40 ; 338 ; 240) en communication fluidique avec ladite entrée de liquide de traitement comprenant un moyen pour communiquer un écoulement idéal le long dudit axe à un premier liquide introduit dans ladite enceinte pour déplacer un second liquide disposé dans celle-ci.

8. Dispositif selon la revendication 7, dans lequel ledit élément d'entrée de liquide comprend un moyen (40 ; 338 ; 240) pour augmenter la zone d'écoulement dudit premier liquide dans un sens transversal audit axe (19 ; 238), augmentant de ce fait la section transversale d'écoulement dudit premier liquide introduit dans ladite enceinte.

9. Dispositif selon la revendication 8, dans lequel ledit moyen pour communiquer un écoulement idéal comprend un moyen (136 ; 236 ; 252 ; 253) pour communiquer audit premier liquide un vecteur d'écoulement transversal audit axe.

10. Dispositif selon la revendication 9, dans lequel ledit moyen pour communiquer un écoulement idéal comprend par exemple une surface fixée hélicoïdale de dérivation d'écoulement (136 ; 236).

11. Dispositif selon la revendication 10, dans lequel ladite surface hélicoïdale de dérivation d'écoulement (136 ; 236) définit un angle de rotation d'environ 2 $\pi$ autour dudit axe.

12. Dispositif selon la revendication 9, dans lequel ledit moyen (136 ; 236 ; 252 ; 253) pour communiquer l'écoulement idéal est disposé en amont dudit moyen (40 ; 338 ; 240) pour augmenter la zone d'écoulement.

13. Dispositif selon la revendication 7 comprenant de plus un orifice d'accès fermable (62 ; 262) disposé dans une paroi de ladite enceinte.

14. Dispositif selon la revendication 7, dans lequel ladite cuve et un élément d'entrée comprennent des joints à ajustement mutuel (22, 24 ; 26, 27) pour raccorder ladite entrée du liquide de traitement audit élément d'entrée du liquide.

15. Dispositif selon la revendication 7, comprenant de plus un moyen (120, 122, 112 ; 352, 354 ; 220, 222, 212) pour introduire un gaz de purge dans ladite enceinte.

16. Dispositif selon la revendication 9, dans lequel ledit moyen pour communiquer un écoulement idéal comprenant une surface de dérivation de l'écoulement (252 ; 253) est monté pour rotation autour dudit axe (238).

17. Dispositif selon la revendication 7, dans lequel ladite enceinte (60 ; 82 ; 83 ; 260 ; 282) comprend :

i) des parois latérales opposées disposées autour d'un axe parallèle au sens d'écoulement du fluide prévues pour enfermer entre celles-ci une pluralité de pastilles et définissant des extrémités ouvertes ;

ii) un moyen (94, 95, 96, 97 ; 70, 72 ; 86, 88 ; 270, 272, 286, 288) pour supporter les pastilles ou au moins un porteur de pastille à l'intérieur desdites parois ;

iii) une ouverture fermable hermétiquement (62 ; 262) définie par au moins une partie d'au moins une desdites parois latérales pour permettre l'introduction et l'enlèvement des pastilles, et

iv) un moyen de fermeture (68 ; 84 ; 268 ; 284) pour engagement d'étanchéité à ajustement mutuel avec ladite ouverture fermable hermétiquement.

18. Dispositif selon la revendication 7, dans lequel l'enceinte (6 ; 10 ; 11 ; 208 ; 290 ; 2110) comporte :

A. une pluralité de cuves séparables (10 ; 11 ; 208 ; 290 ; 2110a, 2110b) en série, en engagement de fermeture hermétique, chacune de celles-ci comprend :

1. des parois latérales opposées disposées autour d'un axe (19 ; 238) parallèle au sens de l'écoulement du fluide, prévu pour enfermer entre celles-ci une pluralité de pastilles, définissant les extrémités ouverte, et

2. Un moyen (15, 17 ; 242 ; 295 ; 16, 18 ; 17, 18) pour supporter un porteur de pastille contenant des pastilles ou des pastilles à l'intérieur desdites parois, et

B. Un premier moyen de fermeture hermétique (22, 24 ; 293) autour d'une extrémité ouverte d'un desdits segments pour engagement de fermeture hermétique d'une entrée de fluide (40 ; 336 ; 240), et

C. un second moyen de fermeture hermétique (26, 27 ; 294) autour d'une extrémité ouverte d'un autre desdits segments pour engagement de fermeture hermétique d'une sortie de fluide (48 ; 338 ; 248).

19. Dispositif selon la revendication 18, dans lequel chacune des cuves comprend ledit premier moyen de fermeture hermétique (22, 24 ; 293) à une extrémité ouverte et ledit second moyen de fermeture hermétique (26, 27 ; 294) à l'autre extrémité ouverte et lesdits premier et second moyens de fermeture hermétiques sont prévus pour s'ajuster mutuellement en engagement de fermeture hermétique avec une cuve de raccordement (106 ; 208'', 2110b).

20. Dispositif selon la revendication 18, comprenant de plus un moyen (340 ; 2140) pour comprimer axialement ladite cuve, l'entrée du liquide et la sortie de traitement pour pousser ledit moyen de fermeture en engagement étanche au fluide.

21. Dispositif selon la revendication 7, comportant une ligne d'écoulement du fluide (112, 50 ; 342, 344 ; 212, 250) et dans lequel la cuve comprend au moins un segment de cuve (10 ; 11 ; 208') comprenant :

1. des parois latérales opposées disposées autour d'un axe (19 ; 238) parallèle au sens d'écoulement du fluide, prévu pour enfermer entre celles-ci une pluralité de pastilles et définissant des extrémités ouverte ;

2. un moyen (15, 17 ; 242 ; 295 ; 16, 18 ; 17, 18) pour supporter un porteur de pastille contenant des pastilles ou des pastilles à l'intérieur desdites parois ;

3. un premier moyen de fermeture étanche (22, 24 ; 293) autour d'une extrémité ouverte pour engagement de fermeture étanche d'un moyen (40 ; 336 ; 240) communiquant avec une partie en amont de ladite ligne d'écoulement de fluide, et

4. Un second moyen de fermeture étanche (26, 27 ; 294) autour de l'autre extrémité ouverte pour engagement de manière étanche d'un moyen (48 ; 338 ; 248) communiquant avec une partie en aval de ladite ligne d'écoulement de fluide ;

et dans lequel le dispositif comporte également un moyen (118, 122, 126, 130 ; 352 ; 218, 222, 226, 230) pour interrompre temporairement l'écoulement du fluide dans ladite ligne afin de permettre l'introduction de ladite cuve à l'intérieur de celle-ci.

22. Dispositif selon la revendication 21, dans lequel lesdits premier et second moyens de fermeture hermétique comprennent un matériau élastomère (24) et ledit matériau élastomère est dilaté vers l'intérieur vers ledit moyen pour supporter les pastilles.

23. Dispositif selon la revendication 21, comprenant de plus un moyen (117, 119 ; 350, 352) pour inverser le sens de l'écoulement du fluide dans ladite ligne d'écoulement de fluide.

24. Dispositif selon la revendication 21, comprenant de plus un moyen (116, 118, 120, 122, 124, 126, 128, 130 ; 216, 218, 220, 222, 224, 226, 228, 230) pour délivrer en série une pluralité de fluides à ladite ligne d'écoulement de fluide pour remplir hydrauliquement ladite cuve.

25. Dispositif selon la revendication 21, dans lequel ledit moyen communiquant avec une partie en amont de ladite ligne d'écoulement de fluide comprend un détendeur ou diffuseur (40 ; 336 ; 240) et ledit moyen communiquant avec une partie en aval de ladite ligne d'écoulement de fluide comprend un extracteur (48 ; 338 ; 248).

26. Dispositif selon la revendication 20, dans lequel ledit moyen pour compression comporte un moyen (340 ; 2140) pour permettre la dilatation de ladite cuve à mesure que le fluide chaud passe à travers celle-ci.

27. Dispositif selon la revendication 21 ou 22 ou 24, dans lequel ladite entrée de fluide comprend un détendeur (40 ; 336 ; 240) et ladite sortie de fluide comprend un extracteur (48 ; 338 ; 248) pour minimiser les écoulements de courants parasites à l'intérieur de ladite cuve.

28. Dispositif selon la revendication 25 ou 27 comprenant un moyen (136 ; 236 ; 252 ; 253) pour communiquer un écoulement idéal à un liquide envoyé à travers ledit détendeur et la cuve pour déplacer un autre liquide disposé dans celle-ci.

29. Dispositif selon la revendication 17, dans lequel ladite ouverture et ledit moyen de fermeture comprennent des bords de raccord ajustés mutuellement ayant un joint d'élastomère (64, 66 ; 264, 266) disposé entre ceux-ci et ledit joint d'élastomère se dilate vers l'intérieur de ladite cuve lorsque ladite ouverture et ledit moyen de fermeture sont engagés en fermeture hermétique.

30. Dispositif selon la revendication 7, comprenant une pluralité desdites cuves (10 ; 11 ; 208 ; 290 ; 2110) disposées le long dudit axe.

31. Cuve (6 ; 10a, 10b ; 10 ; 11 ; 108 ; 208' ; 2110a ; 2110a, 2110b) pour utilisation dans le dispositif de la revendication 7 pour traiter des pastilles semi-conductrices avec un écoulement séquentiel de liquides, ladite cuve enfermant une région de traitement et contenant un moyen (15, 17 ; 242 ; 295 ; 16, 18 ; 17, 18) pour supporter un porteur de pastille contenant des pastilles ou des pastilles dans la région de traitement, ladite cuve ayant des parois latérales opposées prévues pour enfermer entre celles-ci une pluralité de pastilles et définissant des extrémités ouvertes, caractérisée en ce que lesdites extrémités ouvertes sont pratiquement de la même étendue que la région de traitement enfermée par lesdites parois latérales, lesdites extrémités ouverte définissant respectivement ladite entrée du liquide de traitement et ladite sortie du liquide de traitement, et en ce que

le premier moyen de fermeture étanche (22, 24 ; 293) est prévu autour d'une extrémité ouverte pour engagement de fermeture étanche d'un moyen communiquant avec l'entrée du liquide de traitement, et

un second moyen de fermeture étanche (26, 27 ; 294) est prévu autour de l'autre extrémité ouverte pour fermeture étanche d'un moyen communiquant avec la sortie du liquide de traitement.

32. Cuve selon la revendication 31, dans laquelle ledit premier moyen de fermeture étanche comprend une surface (22) pour ajustement mutuel avec l'entrée du liquide de traitement.

33. Cuve selon la revendication 31 comprenant une pluralité de segments de cuve séparables (6 ; 10a, 10b ; 208', 208'' ; 290) en engagement de fermeture hermétique en série, dans laquelle le second moyen de fermeture étanche (26, 27, 294) d'un segment de cuve engage le premier moyen de fermeture étanche (22, 24 ; 293) d'un segment de cuve adjacent pour former une enceinte autour des pastilles définie par lesdits segments de cuve.

**Patentansprüche**

1. Verfahren zum Einwirkenlassen einer Behandlungslösung auf die radialen Oberflächen einer Mehrzahl von Halbleiterscheiben, derart, daß sämtliche Zonen der radialen Oberflächen jeder Scheibe im wesentlichen den gleichen Konzentrationen der Behandlungslösung für im wesentlichen den gleichen Zeitraum ausgesetzt werden, gekennzeichnet durch die Schritte, daß

a. die Mehrzahl von Scheiben in einer Umhüllung (6;10;11;60;82;83;208;260;282;290;2110) angeordnet wird, die einen Behandlungslösungeinlaß gegenüber einem Behandlungslösungsauslaß bildet,

b. eine erste Flüssigkeit in die Umhüllung eingeführt wird,

c. eine Pfropfenströmung der Behandlungslösung entlang einer durch die Umhüllung zwischen dem Einlaß und dem Auslaß angeordneten Achse (19;238) induziert wird, um die erte Flüssigkeit zu verdrängen, und, nach einer gewählten Zeit,

d. eine Pfropfenströmung einer zweiten Flüssigkeit entlang der Achse zum Verdrängen der Behandlungslösung induziert wird.

2. Verfahren nach Anspruch 1, bei dem die Pfropfenströmung durch die Umhüllung dadurch induziert wird, daß

die Behandlungslösung und die zweite Flüssigkeit durch ein zwischen einer Eingabeleitung (112;212;232) und der Umhüllung zwischengeschaltetes Eingabeelement (40;338;240) hindurchgeleitet werden, das eine Einrichtung zum Vergrößern der Strömungsfläche der Flüssigkeit in Querrichtung zu der Achse umfaßt, und

der Strömung der Behandlungslösung und der zweiten Flüssigkeit ein Strömungsvektor quer zu der Achse vermittelt wird.

3. Verfahren nach Anspruch 1, bei dem der Schritt a den Schritt umfaßt, daß,

a. eine Mehrzahl ebener Scheiben in ein Gefäß (10;11;208;2110) gepackt wird, das gegenüberliegende Seitenwände besitzt, die um eine zur Fluidströmungsrichtung parallele Achse (19,238) angeordnet sind und offene Enden (244,246) bilden, wobei die eingepackten Scheiben derart ausgerichtet sind, daß die ebenen Oberflächen jeder Scheibe parallel zu der Achse verlaufen, das Gefäß an den Fluideinlaß angeschlossen ist und der Fluidauslaß im wesentlichen mit den offenen Enden gleich große Abmessungen besitzt, und wobei die Schritte der Einführrung der Flüssigkeit und der Induzierung der Pfropfenströmung die Maßnahme umfassen, daß

b. eine Fluidströmung von dem Fluideinlaß durch das Gefäß in Berührung mit den Seitenwänden und über die ebenen Oberflächen der Mehrzahl von Scheiben sowie zum Fluidauslaß hergestellt wird.

4. Verfahren nach Anspruch 1, bei dem der Schritt a die Schritte umfaßt, daß

a. eine Mehrzahl von Scheiben in ein Gefäß (10;11;208;2110) mit gegenüberliegenden Seitenwänden gepackt wird, die um eine zur Richtung der Fluidströmung parallele Achse (19;238) angeordnet sind und offene Enden bilden,

b. das bepackte Gefäß in eine Behandlungsfluidströmungsleitung (112;212;232) eingesetzt wird,

c. eines der offenen Enden (244) an eine mit einem stromaufwärts gelegenen Bereich (40;338;240) der Strömungsleitung in Verbindung stehenden Einrichtung abdichtend angeschlossen wird und

d. das andere der offenen Enden (246) an eine mit einem stromabwärts gelegenen Bereich (48;336;248) der Strömungsleitung in Verbindung stehenden Einrichtung abdichtend angeschlossen wird.

5. Verfahren nach Anspruch 4, bei dem einer der Schritte c und d dadurch ausgeführt wird, daß die mit einem stromaufwärts gelegenen Bereich (40;338;240) der Fluidströmungsleitung in Verbindung stehende Einrichtung, das Gefäß (10;11;208;2110) und die mit einem stromabwärts gelegenen Bereich (48;336;248) der Fluidströmungsleitung in Verbindung stehende Einrichtung zusammengepreßt werden.

6. Verfahren nach Anspruch 4, bei dem die Schritte b bis d dadurch ausgeführt werden, daß einer Flüssigkeit vor ihrer Einführung in das Gefäß (10;11;208;2110) eine Pfropfenströmung vermittelt wird, um eine andere in dem Gefäß enthaltene Flüssigkeit zu verdrängen.

7. Vorrichtung zur Behandlung von Halbleiterscheiben mit einer Strömungsfolge von Flüssigkeiten, derart, daß sämtliche Zonen der radialen Oberflächen jeder Scheibe im wesentlichen der gleichen Konzentration einer Behandlungslösung für im wesentlichen die gleiche Zeitdauer ausgesetzt werden, gekennzeichnet durch

ein Gefäß (6;10a,10b;60;82;83;208;260;282; 2110a,2110b) zur Aufnahme der Scheiben mit einer Umhüllung, die einen Behandlungsflüssigkeitseinlaß gegenüber einem Behandlungsflüssigkeitsauslaß bildet, wobei die Richtung der Flüssigkeitsströmung durch die Umhüllung zwischen dem Einlaß und dem Auslaß eine Achse (19;238) definiert, und

ein Flüssigkeitseingabeelement (40;338;240) in Fluidverbindung mit dem Behandlungsflüssigkeitseinlaß und mit einer Einrichtung, die dazu dient, einer ersten in die Umhüllung eingeführten Flüssigkeit eine Pfropfenströmung entlang der Achse zu vermitteln, um eine zweite in der Umhüllung befindliche Flüssigkeit zu verdrängen.

8. Vorrichtung nach Anspruch 7, bei der das Flüssigkeitseingabeelement eine Einrichtung (40;338;240) zum Vergrößern der Strömungsfläche der ersten Flüssigkeit in Querrichtung zur Achse (19;238) umfaßt, um dadurch den Strömungsquerschnitt der in die Umhüllung eingeführten ersten Flüssigkeit zu vergrößern.

9. Vorrichtung nach Anspruch 8, bei der die Einrichtung zum Vermitteln der Pfropfenströmung eine Einrichtung (136;236;252;253) umfaßt, die dazu dient, der ersten Flüssigkeit einen Strömungsvektor quer zur Achse zu vermitteln.

10. Vorrichtung nach Anspruch 9, bei der die Einrichtung zum Vermitteln der Pfropfenströmung eine fixe, zum Beispiel schraubenlinienförmige Strömungsablenkoberfläche (136;236) umfaßt.

11. Vorrichtung nach Anspruch 10, bei der die schraubenlinienförmige Strömungsablenkoberfläche (136;136) einen Rotationswinkel von etwa $2\pi$ um die Achse definiert.

12. Vorrichtung nach Anspruch 9, bei der die Einrichtung (136;236;252;253) zum Vermitteln der Pfropfenströmung stromaufwärts der Einrichtung (40;338;240) zum Vergrößern der Strömungsfläche angeordnet ist.

13. Vorrichtung nach Anspruch 7, ferner mit einer abdichtend verschließbaren Zugangsöffnung (62;262) in einer Wand der Umhüllung.

14. Vorrichtung nach Anspruch 7, bei der das Gefäß und das Eingabeelement ineinander passende Dichtungen (22,24;26,27) zum Verbinden des Behandlungsflüssigkeitseinlasses mit dem Flüssigkeitseingabeelement umfassen.

15. Vorrichtung nach Anspruch 7, ferner mit einer Einrichtung (120,122,112;352,354;220,222,212) zum Einführen eine Spülgases in die Umhüllung.

16. Vorrichtung nach Anspruch 9, bei der die Einrichtung zum Vermitteln der Pfropfenströmung eine drehbar um die Achse (238) montierte Strömungsablenkoberfläche (252;253) umfaßt.

17. Vorrichtung nach Anspruch 7, bei der die Umhüllung (60;82;83;260;282) umfaßt:
i) gegenüberliegende Seitenwände, die um eine zur Fluidströmungsrichtung parallele Achse angeordnet sind, geeignet sind, zwischen sich eine Mehrzahl von Scheiben einzuschließen, und offene Enden bilden,
ii) eine Einrichtung (94,95,96,97;70,72;86,88; 270,272,286,288) zum Abstützen der Scheiben oder zumindest eines Scheibenträgers innerhalb der Wände,
iii) eine von zumindest einem Bereich zumindest einer der Seitenwände gebildete verschließbare Öffnung (62;262) zur Ermöglichung des Einsetzens und der Entnahme von Scheiben und
iv) eine Verschließeinrichtung (68;84;268;284) für einen ineinanderpassenden Dichtungseingriff mit der verschließbaren Öffnung.

18. Vorrichtung nach Anspruch 7, bei der die Umhüllung (6;10;11;208;290;2110) umfaßt:
A. eine Mehrzahl trennbarer Gefäße (10;11;208; 290;2110a,2110b) in reihenförmigem Dichtungseingriff, jeweils bestehend aus
1. gegenüberliegenden Seitenwänden, die um eine zur Fluidströmungsrichtung parallele Achse (19;238) angeordnet sind, geeignet sind, zwischen sich eine Mehrzahl von Scheiben einzuschließen, und offene Enden bilden, und
2. einer Einrichtung (15,17;242;295;16,18;17,18) zum Abstützen eines Scheiben enthaltenden Scheibenträgers oder von Scheiben innerhalb der Wände und
B. eine erste Abdichtungseinrichtung (22,23;393) um ein offenes Ende eines der Segmente für einen Abdichtungseingriff mit einem Fluideinlaß (40;336;240) und
C. eine zweite Dichtungseinrichtung (26,27;294) um ein offenes Ende eines weiteren der Segmente für einen Dichtungseingriff mit einem Fluidauslaß (48;338;248).

19. Vorrichung nach Anspruch 18, bei der jedes der Gefäße die erste Abdichtungseinrichtung (22,24;293) an einem offenen Ende und die zweite Abdichtungseinrichtung (26,27;294) an einem anderen offenen Ende umfaßt und die erste und die zweite Abdichtungseinrichtung für einen ineinanderpassenden Dichtungseingriff mit einem zusammenpassenden Gefäß (106;208'';2110b) geeignet sind.

20. Vorrichtung nach Anspruch 18, ferner mit einer Einrichtung (340;2140) zum axialen Zusammenpressen des Gefäßes, des Behandlungsflüssigkeitseinlasses und des Behandlungsauslasses zum Drücken der Abdichtungseinrichtung in einen fluiddichten Eingriff.

21. Vorrichtung nach Anspruch 7, die eine Fluidströmungsleitung (112,50;342,344;212,250) aufweist und bei der das Gefäß zumindest ein Gefäßsegment (10;11;208') umfaßt, bestehend aus
1. gegenüberliegenden Seitenwänden, die um eine zur Fluidströmungsrichtung parallele Achse (19;238) angeordnet sind, geeignet sind, zwischen sich eine Mehrzahl von Scheiben einzuschließen, und offene Enden bilden,
2. einer Einrichtung (15,17;242;295;16,18;17,18) zum Abstützen eines Scheiben enthaltenden Scheibenträgers oder von Scheiben innerhalb der Wände,
3. einer ersten Abdichtungseinrichtung (22,24;293) um ein offenes Ende für einen Dichtungseingriff mit einer mit einem stromaufwärts gelegenen Bereich der Fluidströmungsleitung in Verbindung stehenden Einrichtung (40;336;240) und
4. einer zweiten Abdichtungseinrichtung (26,27;294) um das andere offene Ende für einen Dichtungseingriff mit einer mit einem stromabwärts gelegenen Bereich der Fluidströmungsleitung in Verbindung stehenden Einrichtung (48;338;248),
und wobei die Vorrichtung ferner eine Einrichtung (118,122,126,130;352;218,222,226,230) zum zeitweiligen Unterbrechen der Fluidströmung in der Leitung aufweist, um das Einsetzen des Gefäßes in diese zu ermöglichen.

22. Vorrichtung nach Anspruch 21, bei der die erste und die zweite Abdichtungseinrichtung ein elastomeres Material (24) umfaßt und das elastomere Material nach innen zu der Einrichtung zur Scheibenabstützung hin ausgedehnt ist.

23. Vorrichtung nach Anspruch 21, ferner bestehend aus einer Einrichtung (117,119;350,352) zum Umkehren der Fluidströmungsrichtung in der Fluidströmungsleitung.

24. Vorrichtung nach Anspruch 21, ferner bestehend aus einer Einrichtung (116,118,120,122,124,126,128,130;216,218,220, 222,224,226,228,230), die dazu dient, der Reihe nach mehrere Fluids der Fluidströmungsleitung zuzuführen, um das Gefäß hydraulisch zu füllen.

25. Vorrichtung nach Anspruch 21, bei der die mit einem stromaufwärts gelegenen Bereich der Fluidströmungsleitung in Verbindung stehende Einrichtung ein Ausdehnungsorgan bzw. einen Diffusor (40;336;240) und die mit einem stromabwärts gelegenen Bereich der Fluidströmungsleitung in Verbindung stehende Einrichtung ein Abziehorgan (48;338;248) umfaßt.

26. Vorrichtung nach Anspruch 20, bei der die Einrichtung zum Zusammenpressen eine Einrichtung (340;2140) zur Ermöglichung einer Ausdehnung des Gefäßes bei einem Durchgang eines heißen Fluids durch dieses aufweist.

27. Vorrichtung nach Anspruch 21, 22 oder 24, bei der der Fluideinlaß ein Ausdehnungsorgan (40;336;240) und der Fluidauslaß ein Abziehorgan (48;338;248) zur Minimierung einer Wirbelströmung innerhalb des Gefäßes umfaßt.

28. Vorrichtung nach Anspruch 25 oder 27 mit einer Einrichtung (136;236;252;253), die dazu dient, einer durch das Ausdehnungsorgan und das Gefäß hindurchgeleiteten Flüssigkeit eine Pfropfenströmung zum Verdrängen einer anderen in dem Gefäß befindlichen Flüssigkeit zu vermitteln.

29. Vorrichtung nach Anspruch 17, bei der die Öffnung und die Verschließeinrichtung zusammenpassende Ränder mit einer dazwischen angeordneten elastomeren Dichtung (64,66;264,266) umfassen und die elastomere Dichtung zum Inneren des Gefäßes hin ausgedehnt ist, wenn die Öffnung und die Verschließeinrichtung in Dichtungseingriff stehen.

30. Vorrichtung nach Anspruch 7, mit einer Mehrzahl der Gefäße (10;11;208;290;2110) in einer Anordnung entlang der Achse.

31. Gefäß (6;10a,10b;10;11;208;208';2110a;2110a,2110b) zur Verwendung in der Vorrichtung nach Anspruch 7 zum Behandeln von Halbleiterscheiben mit einer aufeinanderfolgenden Strömung von Flüssigkeiten, wobei das Gefäß eine Behandlungszone umhüllt und eine Einrichtung (15,17;242;295;16,18;17,18) zum Abstützen eines Scheiben enthaltenden Scheibenträgers oder von Scheiben in der Behandlungszone enthält und das Gefäß ferner gegenüberliegende Seitenwände besitzt, die geeignet sind, zwischen sich eine Mehrzahl der Scheiben einzuschließen, und offene Enden bilden, dadurch gekennzeichnet, daß die offenen Enden im wesentlichen die gleiche Ausdehnung wie die von den Seitenwänden umschlossene Behandlungszone aufweisen und die offenen Enden den Behandlungsflüssigkeitseinlaß bzw. den Behandlungsflüssigkeitsauslaß bilden, und daß eine erste Abdichtungseinrichtung (22,24;293) um ein offenes Ende für einen Dichtungseingriff mit einer mit dem Behandlungsflüssigkeitseinlaß in Verbindung stehenden Einrichtung vorgesehen ist und eine zweite Abdichtungseinrichtung (26,27;294) um das andere offene Ende für einen Dichtungseingriff mit einer mit dem Behandlungsflüssigkeitsauslaß in Verbindung stehenden Einrichtung vorgesehen ist.

32. Gefäß nach Anspruch 31, bei dem die erste Dichtungseinrichtung eine Oberfläche (22) für eine Paßverbindung mit dem Behandlungsflüssigkeitseinlaß umfaßt.

33. Gefäß nach Anspruch 31, bestehend aus mehreren trennbaren Gefäßsegmenten (6;10a,10b;208',208'';290) in reihenförmigem Dichtugnseingriff, wobei die zweite Abdichtungseinrichtung (26,27,294) eines Gefäßsegmentes mit der ersten Abdichtungseinrichtung (22,24;293) eines benachbarten Gefäßsegmentes zur Bildung einer von den Gefäßsegmenten definierten Umhüllung um die Scheiben in Eingriff steht.

FIG. 1A

FIG. 1B

FIG. 2B

FIG. IC

FIG. 1D

FIG. 1E

FIG. 2A

FIG. 3

FIG. 4

FIG. 5

FIG. 6

TO RECLAMATION

TO WASTE

TO NITROGEN

TO FLUID(S)

344

352

336

390

10a

332

10b

334

338

350

TO FLUID(S)

342

340

TO DRAIN

FIG. 7

FIG. 8

FIG. 9

FIG. 10

FIG. 11

*FIG.12*

TO RECLAMATION

TO WASTE

FIG.13A

FIG. 13B

FIG. 14A

FIG. 13C

FIG. 14B

FIG. 14C

FIG. 15A

FIG. 15B